# EUROPEAN PATENT APPLICATION

(11) **EP 4 727 309 A1**
(43) Date of publication of application: **15.04.2026**
(21) Application number: 25205910.0
(22) Date of filing: 30.09.2025
(51) Int. Cl.: H10H 29/80, H10H 29/01, H10H 29/34, H10H 29/39

(54) **LIGHT-EMITTING DEVICE, DISPLAY APPARATUS INCLUDING THE SAME, AND METHOD OF MANUFACTURING THE SAME**

(30) Priority: 08.10.2024 KR 20240136795
(71) Applicant: Samsung Electronics Co., Ltd., Suwon-si, Gyeonggi-do 16677 (KR)
(72) Inventor: Shin, Dongchul, 16677 Suwon-si (KR); Kim, Joosung, 16678 Suwon-si (KR); Oh, Youngtek, 16677 Suwon-si (KR); Hwang, Kyungwook, 16677 Suwon-si (KR); Park, Junghun, 16677 Suwon-si (KR)
(74) Representative: Arnold & Siedsma

(57) **Abstract**

Provided is a display apparatus including a light-emitting device that includes a light-emitting structure including a first light-emitting element and a second light-emitting element, a first electrode pattern including a first electrode and a second electrode electrically connected to the p-type semiconductor layer of the first light-emitting element and the p-type semiconductor layer of the second light-emitting element, and a second electrode pattern electrically connected to the n-type semiconductor layer of the first light-emitting element and the n-type semiconductor layer of the second light-emitting element, the second electrode including a first insulating hole, a first p-type contact layer in the first insulating hole and contacting the p-type semiconductor layer of the second light-emitting element, and a first conductive layer contacting the first p-type contact layer.

## Description

### BACKGROUND

### 1. Field

Embodiments of the present disclosure relate to a light-emitting device, a display apparatus including the light-emitting device, and a method of manufacturing a light-emitting device.

### 2. Description of Related Art

Light-emitting diodes (LEDs) are known as the next-generation light sources due to their advantages such as relatively long lifespan, low power consumption, fast response speed, and environmental friendliness compared to conventional light sources. Because of these advantages, the industrial demand for LEDs is increasing. LEDs have been generally applied and used in various products such as lighting devices and backlights of display apparatuses. Recently, micro units of micro-LEDs using group II-VI or group III-V compound semiconductors have been developed.

In addition, micro-LED displays including micro-LEDs directly used as light-emitting devices of display pixels have been developed. A method of manufacturing a light-emitting element for each sub-pixel and a method of manufacturing a light-emitting element for each pixel have been researched.

### SUMMARY

One or more embodiments provide a monolithic light-emitting device having an epitaxial structure in which a plurality of light-emitting elements emitting light of different wavelengths are vertically stacked, a display apparatus including the monolithic light-emitting device, and a method of manufacturing the monolithic light-emitting device.

One or more embodiments also provide a monolithic light-emitting device with improved electrical characteristics between those of a light-emitting element and an electrode, a display apparatus including the monolithic light-emitting device, and a method of manufacturing the monolithic light-emitting device.

According to an aspect of the present disclosure, there is provided a light-emitting device as defined in any of the appended claims 1-12.

According to another aspect of the present disclosure, there is provided a display apparatus as defined in appended claim 13 or 14.

According to still another aspect of the present disclosure, there is provided a method of manufacturing a light-emitting device as defined in appended claim 15.

Additional aspects will be set forth in part in the description which follows and, in part, will be apparent from the description, or may be learned by practice of one or more embodiments.

### BRIEF DESCRIPTION OF DRAWINGS

The above and other aspects, features, and advantages of one or more embodiments will be more apparent from the following description taken in conjunction with the accompanying drawings, in which:
FIG. 1 is a cross-sectional view illustrating a light-emitting device according to one or more embodiments;
FIG. 2 is a diagram illustrating a light-emitting device according to one or more other embodiments;
FIG. 3 is a diagram illustrating a light-emitting device according to one or more other embodiments;
FIG. 4 is a diagram illustrating a light-emitting device including three light-emitting elements according to one or more embodiments;
FIG. 5 is a diagram illustrating a light-emitting device including electrode patterns disposed on the same surface of a light-emitting structure according to one or more embodiments;
FIG. 6 is a diagram illustrating a light-emitting device including a first reflective layer according to one or more embodiments;
FIG. 7 is a diagram illustrating a light-emitting device including a fourth insulating layer according to one or more embodiments;
FIG. 8 is a diagram illustrating a light-emitting device including a second reflective layer according to one or more embodiments;
FIG. 9 is a block diagram of a display apparatus including a light-emitting device according to one or more embodiments;
FIG. 10 is a diagram illustrating a portion of a display apparatus including a plurality of light-emitting devices according to one or more embodiments;
FIG. 11 is a diagram illustrating a display apparatus including a pixel partition according to one or more embodiments;
FIG. 12 is a diagram illustrating a display apparatus including an optical layer controlling an optic path according to one or more embodiments;
FIG. 13 is a diagram illustrating a display apparatus to which light-emitting devices are connected according to one or more embodiments;
FIGS. 14, 15, 16, 17, 18, 19, 20, 21, 22, 23, and 24 are reference diagrams for describing a method of manufacturing a display apparatus according to one or more embodiments;
FIG. 25 is a diagram illustrating an example of applying a display apparatus according to one or more embodiments to a mobile device;
FIG. 26 is a diagram illustrating an example of applying a display apparatus according to one or more embodiments to a vehicle;
FIG. 27 is a diagram illustrating an example of applying a display apparatus according to one or more embodiments to augmented reality glasses or virtual reality glasses;
FIG. 28 is a diagram illustrating an example of applying a display apparatus according to one or more embodiments to a large signage; and
FIG. 29 is a diagram illustrating an example of applying a display apparatus according to one or more embodiments to a display of a wearable device.

### DETAILED DESCRIPTION

Reference will now be made in detail to embodiments, examples of which are shown in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, the embodiments will be described in detail with reference to the accompanying drawings. The embodiments described below are merely exemplary, and various modifications are possible from these embodiments. In the following drawings, the same reference numerals refer to the same components, and the size of each component in the drawings may be exaggerated for clarity and convenience of description.

Hereinafter, what is described as "above" or "on" may include those directly on, underneath, left, and right in contact, as well as above, below, left, and right in non-contact.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

In addition, terms such as "unit" and "module" described in the specification mean a unit that processes at least one function or operation, and this may be implemented as hardware or software, or may be implemented as a combination of hardware and software.

The specific implementations described in the embodiment are examples and are not intended to limit the technical scope in any way. For the sake of brevity of the specification, descriptions of conventional electronic components, control systems, software, and other functional aspects of the systems may be omitted. Connections of lines or connection members between elements shown in the drawings are illustrative of functional connections and/or physical or circuitry connections, and may be replaced in an actual device, or may be represented as additional various functional connections, physical connections, or circuitry connections.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

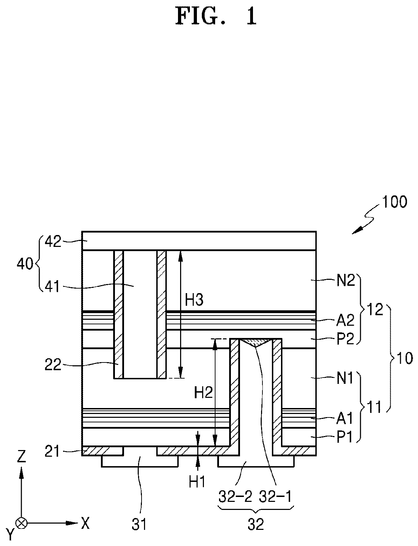

FIG. 1 is a cross-sectional view of a light-emitting device 100 according to one or more embodiments.

Referring to FIG. 1, the light-emitting device 100 according to one or more embodiments may include an inorganic light-emitting diode (LED) and emit light of a specific wavelength according to a material included in the light-emitting device 100. The light-emitting device 100 according to one or more embodiments may have a micro size. For example, a width W of the light-emitting device 100 may be less than or equal to about 10 µm, less than or equal to about 5 µm, or less than or equal to about 3 µm in a horizontal direction (X-direction and/or Y-direction, or a direction perpendicular to a thickness direction of the light-emitting structure).

The light-emitting device 100 according to one or more embodiments may include a light-emitting structure 10 including first light-emitting element 11 and the second light-emitting element 12 configured to emit light of different wavelengths and being monolithically stacked. A cross-section parallel to the light-emitting structure 10 in the horizontal direction (X-direction and/or Y-direction, or a direction perpendicular to a thickness direction of the light-emitting structure), that is, a transverse section, may be circular, elliptical, and/or polygonal. For example, the transverse section of the light-emitting structure 10 may have a rectangular shape. A cross-section parallel to the light-emitting structure 10 in a vertical direction (Z direction, or a thickness direction of the light-emitting structure) may have a rectangular shape. For example, a side cross-section of a body 110 may have a rectangular shape or trapezoidal shape.

The light-emitting structure 10 may be a structure in which a first light-emitting element 11 emitting light of a first wavelength and a second light-emitting element 12 emitting light of a second wavelength different from the first wavelength are stacked in the vertical direction (Z direction, or a thickness direction of the light-emitting structure) of the light-emitting structure 10. For example, the first light-emitting element 11 may emit light of a wavelength longer than that of the second light-emitting element 12. As will be described below, the light-emitting structure 10 may be formed by sequentially and monolithically growing the second light-emitting element 12 and the first light-emitting element 11 on one sacrificial layer. Thus, the light-emitting structure 10 may not include a bonding material for coupling neighboring and adjacent light-emitting elements.

The first light-emitting element 11 may include a p-type semiconductor layer P1, an active layer A1 disposed on the p-type semiconductor layer P1, and an n-type semiconductor layer N1 disposed on the active layer A1. The p-type semiconductor layer P1, the active layer A1, and the n-type semiconductor layer N1 may have a vertical stack structure.

The p-type semiconductor layer P1 and the n-type semiconductor layer N1 may include a group II-VI or group III-V compound semiconductor material, in particular a nitride semiconductor material. For example, the p-type semiconductor layer P1 and the n-type semiconductor layer N1 may include at least one nitride semiconductor material among indium aluminum gallium nitride (InAlGaN), gallium nitride (GaN), aluminum gallium nitride (AlGaN), indium gallium nitride (InGaN), aluminum nitride (AlN), and indium nitride (InN). The p-type semiconductor layer P1 and the n-type semiconductor layer N1 may serve to provide electrons and holes to the active layer A1. The p-type semiconductor layer P1 may be doped with a p-type dopant, and the n-type semiconductor layer N1 may be doped with an n-type dopant electrically different from the p-type dopant. The n-type semiconductor layer N1 may include silicon (Si), germanium (Ge), tin (Sn), etc. as a dopant, and the p-type semiconductor layer P1 may include magnesium (Mg), zinc (Zn), etc. as a dopant. The n-type semiconductor layer N1 may provide electrons to the active layer A1, and the p-type semiconductor layer P1 may provide holes to the active layer A1.

The active layer A1 may be disposed between the p-type semiconductor layer P1 and the n-type semiconductor layer N1. The active layer A1 has a quantum well structure in which a quantum well is disposed between barriers. Light may be generated as electrons and holes provided in the p-type semiconductor layer P1 and the n-type semiconductor layer N1 are recombined in the quantum well in the active layer A1. A wavelength of light generated from the active layer A1 may be according to an energy band gap of a material constituting the quantum well in the active layer A1. The active layer A1 may have one quantum well, but may have a multi-quantum well (MQW) structure in which a plurality of quantum well and a plurality of barriers are alternately disposed. A thickness of the active layer A1 in the vertical direction (Z direction, or a thickness direction of the light-emitting structure) or the number of quantum wells in the active layer A1 may be appropriately selected in consideration of a voltage applied to the first light-emitting element 11 and light emission efficiency. The active layer A1 may include a group II-VI or group III-V compound semiconductor material, in particular a nitride semiconductor material. For example, the active layer A1 may include at least one nitride semiconductor material among InGaN, GaN, AlGaN, and AlInGaN.

When the active layer A1 includes indium (In), as the indium content decreases a wavelength of light emitted by the active layer A1 may decrease. For example, in the active layer A1 including InGaN or AlInGaN, when the indium content in the nitride semiconductor material is about 35 at%, the active layer A1 may emit red light of about 630 nm, when the indium content is about 30 at%, the active layer A1 may emit yellow light of about 560 nm, and when the indium content is about 25 at%, the active layer A1 may emit green light of about 320 nm. In addition, when the indium content is about 15 at%, the active layer A1 may emit blue light of about 450 nm.

The second light-emitting element 12 may be disposed on the first light-emitting element 11. Like the first light-emitting element 11, the second light-emitting element 12 may include a p-type semiconductor layer P2, an active layer A2, and an n-type semiconductor layer N2, and have a vertical stack structure. The p-type semiconductor layer P2 and the n-type semiconductor layer N2 of the second light-emitting element 12 may be respectively the same as the p-type semiconductor layer P1 and the n-type semiconductor layer N1 of the first light-emitting element 11. For example, the p-type semiconductor layer P2 and the n-type semiconductor layer N2 of the second light-emitting element 12 may include at least one nitride semiconductor material among InAlGaN, GaN, AlGaN, InGaN, AlN, and InN.

The active layer A2 of the second light-emitting element 12 may have a different composition of the nitride semiconductor material from a composition of the nitride semiconductor material of that of the active layer A1 of the first light-emitting element 11. Thus, the second light-emitting element 12 may emit light of a different wavelength band from the first light-emitting element 11. The active layer A2 of the second light-emitting element 12 may have a lower indium content than an indium content of the active layer A1 of the first light-emitting element 11.

As the size of a light-emitting element decreases, the current density applied to the light-emitting element may increase. When the current density increases, because the external quantum efficiency in the light-emitting element decreases, the light emission efficiency of the light-emitting element may also decrease. In the light-emitting device 100 according to one or more embodiments, because the first light-emitting element 11 and the second light-emitting element 12 emitting light of different wavelengths are stacked in a vertical direction, that is, a light emission direction (e.g., the Z direction), the active layers A1 and A2 of relatively wide areas may be secured. The active layers A1 and A2 of wide areas may reduce the current density applied to the first light-emitting element 11 and the second light-emitting element 12, and the reduced current density may increase the external quantum efficiency and increase the light emission efficiency of the first light-emitting element 11 and the second light-emitting element 12.

The first light-emitting element 11 and the second light-emitting element 12 have been described with respect to the minimum configurations necessary for basic operations, but embodiments are not limited thereto. At least one of the first light-emitting element 11 and the second light-emitting element 12 may further include various layers for improving performance. For example, a carrier blocking layer and/or stress relief layers may be further disposed between the p-type semiconductor layers P1 and P2 and the active layers A1 and A2, and between the active layers A1 and A2 and the n-type semiconductor layers N1 and N2. Hereinafter, the minimum configurations necessary for basic operations of the first light-emitting element 11 and the second light-emitting element 12 will be described for convenience of description.

The light-emitting device 100 according to one or more embodiments may include a first insulating layer 21 disposed on a lower surface of the light-emitting structure 10. The first insulating layer 21 may include silicon oxide (SiO₂). In the light-emitting structure 10, the first insulating layer 21, the first light-emitting element 11, and the second light-emitting element 12 are sequentially arranged in the vertical direction (Z direction, or a thickness direction of the light-emitting structure), and the lower surface of the first insulating layer 21 may be a lower surface of the light-emitting structure 10, and an upper surface of the second light-emitting element 12 may be an upper surface of the light-emitting structure 10.

The light-emitting device 100 according to one or more embodiments may further include one or more holes penetrating a partial area of the light-emitting structure 10. For example, a first hole H1 penetrating the first insulating layer 21 to expose the p-type semiconductor layer P1 of the first light-emitting element 11, a second hole H2 penetrating the first insulating layer 21 and the first light-emitting element 11 from the lower surface of the light-emitting structure 10 to expose the p-type semiconductor layer P2 of the second light-emitting element 12, and a third hole H3 penetrating the second light-emitting element 12 from the upper surface of the light-emitting structure 10 (the upper surface of the second light-emitting element 12) to expose the n-type semiconductor layer N1 of the first light-emitting element 11 may be disposed in the light-emitting structure 10. The first to third holes H1, H2, and H3 may be spatially spaced apart from each other.

Because the second hole H2 and the third hole H3 partially penetrate the active layers A1 and A2 of the light-emitting structure 10, the areas of the active layers A1 and A2 may be reduced. The width of each of the second hole H2 and the third hole H3 may be equal to or less than 1/5 of the width of the light-emitting structure 10 in the horizontal direction (X-direction and/or Y-direction, or a direction perpendicular to a thickness direction of the light-emitting structure). For example, the width of each of the second hole H2 and the third hole H3 may be less than or equal to about 1 µm and less than or equal to about 0.5 µm in the horizontal direction (X-direction and/or Y-direction, or a direction perpendicular to a thickness direction of the light-emitting structure).

The light-emitting device 100 according to one or more embodiments may further include a second insulating layer 22 provided on and surrounding side surfaces of holes formed inside the light-emitting structure 10, that is, the second hole and the third holes H2 and H3. The second insulating layer 22 may include a transparent insulating material. For example, the second insulating layer 22 may include SiO₂, silicon nitride (SiN), aluminum oxide (Al₂O₃), etc. The second hole H2 and the second insulating layer 22 may be collectively referred to as a second insulating hole, and the third hole H3 and the second insulating layer 22 may be collectively referred to as a third insulating hole. Hereinafter, for convenience of description, the expression "hole" may mean an insulating hole.

The light-emitting device 100 according to one or more embodiments may further include a first electrode pattern 30 exposed on the lower surface of the light-emitting structure 10 (i.e., the lower surface of the first insulating layer 21) while being electrically connected to the p-type semiconductor layers P1 and P2 of the light-emitting structure 10 and a second electrode pattern 40 exposed on the upper surface of the light-emitting structure 10 (i.e., the upper surface of the second light-emitting element 12 or the upper surface of the n-type semiconductor layer N2 of the second light-emitting element 12) while being electrically connected to the n-type semiconductor layers N1 and N2 of the light-emitting structure 10. For example, the first electrode pattern 30 may protrude from the surface of the first insulating layer 21 while being electrically connected to the p-type semiconductor layers P1 and P2 of the light-emitting structure 10 by using one or more holes. The second electrode pattern 40 may protrude from the surface of the n-type semiconductor layer N2 of the second light-emitting element 12 while being electrically connected to the n-type semiconductor layers N1 and N2 of the light-emitting structure 10 by using one or more holes.

The first light-emitting element 11 and the second light-emitting element 12 may receive a common voltage through one of the first electrode pattern 30 and the second electrode pattern 40, and may receive an independent driving voltage through the other one of the first electrode pattern 30 and the second electrode pattern 40. As the first electrode pattern 30 is exposed on the lower surface of the light-emitting structure 10, and the second electrode pattern 40 is exposed on the upper surface of the light-emitting structure 10, because the first electrode pattern 30 and the second electrode pattern 40 are formed on different surfaces of the light-emitting structure 10, a combination of a module providing a voltage and electrode patterns may be easily performed.

The first electrode pattern 30 may include a first electrode 31 electrically connected and/or physically to the p-type semiconductor layer P1 of the first light-emitting element 11 and a second electrode 32 electrically and/or physically connected to the p-type semiconductor layer P2 of the second light-emitting element 12. The first electrode 31 may extend on the surface of the first insulating layer 21 while filling the first hole H1.

The second electrode 32 may include a first p-type contact layer 32-1 in contact with the p-type semiconductor layer P2 of the second light-emitting element 12 and a first conductive layer 32-2 in contact with the first p-type contact layer 32-1 and disposed in the second hole H2 including the second insulating layer 22, that is, the insulating hole.

The first p-type contact layer 32-1 may include the same material as the p-type semiconductor layer P2 of the second light-emitting element 12. For example, the first p-type contact layer 32-1 may include a group II-VI or group III-V compound semiconductor material, for example, a nitride semiconductor material. The first p-type contact layer 32-1 may include a p-type dopant, for example, magnesium (Mg), zinc (Zn), etc.

The second hole H2 may be performed through a plasma etching process. In a process of forming the second hole H2 through the plasma etching process, the exposed p-type semiconductor layer P2 of the second light-emitting element 12 may be damaged, and thus diode junction characteristics or p-type semiconductor characteristics may be lost.

P-type semiconductor characteristics may be restored by forming the first p-type contact layer 32-1 on the exposed p-type semiconductor layer P2 of the second light-emitting element 12. The content of a p-type dopant in the first p-type contact layer 32-1 may be greater than or equal to the content of a p-type dopant in the p-type semiconductor layer P2 of the second light-emitting element 12. The first p-type contact layer 32-1 may be grown on the p-type semiconductor layer P2 of the second light-emitting element 12. A carrier (e.g., a hole) included in the first p-type contact layer 32-1 may diffuse to the p-type semiconductor layer P2 of the second light-emitting element 12 to restore the p-type semiconductor characteristics of the p-type semiconductor layer P2.

A thickness of an edge (peripheral) area of the first p-type contact layer 32-1 and a thickness of a middle (central) area of the first p-type contact layer 32-1 in the vertical direction (Z direction, or a thickness direction of the light-emitting structure) may be different from each other. The thickness of the first p-type contact layer 32-1 may gradually increase from the edge (periphery) area of the first p-type contact layer 32-1 to the middle (central) area of the first p-type contact layer 32-1. For example, the cross-sectional shape of the first p-type contact layer 32-1 in the thickness direction of the light-emitting element 10 may be a triangle. As another example, the surface of the first p-type contact layer 32-1 may be an r-plane surface. Because the surface of the first p-type contact layer 32-1 has a convex shape, a contact area of the first p-type contact layer 32-1 with the first conductive layer 32-2 may increase. Thus, contact resistance between the first p-type contact layer 32-1 and the first conductive layer 32-2 may be reduced.

The first conductive layer 32-2 may protrude to the surface of the first light-emitting element 11 while filling the second hole H2. For example, the first conductive layer 32-2 and the first p-type contact layer 32-1 may be arranged to partially overlap in a direction (e.g., X direction) perpendicular to the vertical direction (Z direction, or a thickness direction of the light-emitting structure) of the light-emitting structure 10.

The second electrode 32 according to one or more embodiments includes the first p-type contact layer 32-1, and thus the p-type semiconductor layer P2 of the second light-emitting element 12 may restore the p-type semiconductor characteristics even though the p-type semiconductor characteristics are damaged.

The second electrode pattern 40 may include a third electrode 41 electrically connected to the n-type semiconductor layer N1 of the first light-emitting element 11 and a fourth electrode 42 electrically connected to the n-type semiconductor layer N2 of the second light-emitting element 12. The third electrode 41 may have a conductive via shape filling the third hole H3, and the fourth electrode 42 may have a conductive pad shape disposed on the n-type semiconductor layer N3 of the second light-emitting element 12.

The first electrode 31 may penetrate the first insulating layer 21 to be in contact with the p-type semiconductor layer P1 of the first light-emitting element 11, and the third electrode 41 may penetrate the second light-emitting element 12 to be in contact with the n-type semiconductor layer N1 of the first light-emitting element 11. In other words, the first electrode 31 may be in contact with the surface of the p-type semiconductor layer P1 of the first light-emitting element 11 while filling the first hole H1, and may extend onto the first insulating layer 21. The third electrode 41 may be in contact with the n-type semiconductor layer N1 of the first light-emitting element 11 while filling the third hole H3 penetrating the second light-emitting element 12. The first light-emitting element 11 may emit first light of a specific wavelength based on an electrical signal applied through the first electrode 31 and the third electrode 41.

The second electrode 32 may penetrate the first insulating layer 21 and the first light-emitting element 11 to be in contact with the p-type semiconductor layer P2 of the second light-emitting element 12, and the fourth electrode 42 may be in contact with the n-type semiconductor layer N2 of the second light-emitting element 12. For example, the second electrode 32 may be in contact with the p-type semiconductor layer P2 of the second light-emitting element 12 while filling the second hole H2 penetrating the first insulating layer 21 and the first light-emitting element 11, and may extend onto the first insulating layer 21. The fourth electrode 42 may be in contact with the n-type semiconductor layer N2 of the second light-emitting element 12. The second light-emitting element 12 may emit second light of a different wavelength from the first light based on an electrical signal applied through the second electrode 32 and the fourth electrode 42. The second light may have a wavelength shorter than a wavelength of the first light.

When the first electrode pattern 30 applies an independent driving voltage to each of the first light-emitting element 11 and the second light-emitting element 12, the first electrode 31 and the second electrode 32 may be disposed not to be connected to each other. When the second electrode pattern 40 applies a common voltage to the first light-emitting element 11 and the second light-emitting element 12, the third electrode 41 and the fourth electrode 42 may be disposed to be connected to each other. For example, the fourth electrode 42 may be disposed on the upper surface of the light-emitting structure 10, that is, on the upper surface of the n-type semiconductor layer N2 of the second light-emitting element 12 while being in contact with the third electrode 41. However, embodiments are not limited thereto. Even when the second electrode pattern 40 applies the common voltage to the first light-emitting element 11 and the second light-emitting element 12, the third electrode 41 and the fourth electrode 42 may be disposed not to be connected to each other.

At least one of the first electrode pattern 30 or the second electrode pattern 40 may include a transparent conductive material. For example, at least one of the first conductive layer 32-2 of the second electrode 32 or the second electrode pattern 40 may include a conductive oxide such as an indium tin oxide (ITO), an indium zinc oxide (IZO), zinc oxide (ZnO), and indium tin zinc oxide (ITZO), a conductive polymer such as PEDOT, etc. As another example, a part of the first electrode patterns 30 may include a non-transparent conductive material or a conductive material having reflective characteristics. For example, an area derived from the first insulating layer 21 among the first electrode 31 and the first conductive layer 32-2 of the second electrode 32 may include a conductive material having reflective characteristics. One of the first electrode 31 and the first conductive layer 32-2 of the second electrode 32 may include a metal material, for example, silver (Ag), gold (Au), platinum (Pt), nickel (Ni), chromium (Cr), and/or aluminum (Al), , but is not limited thereto.

It has been described above that the first light-emitting element 11 emits light of a wavelength longer than a wavelength of the second light-emitting element 12, but embodiments are not limited thereto. The first light-emitting element 11 may emit light of a wavelength shorter than a wavelength of the second light-emitting element 12, and wavelengths of light emitted from the first light-emitting element 11 and the second light-emitting element 12 may be determined according to an application example.

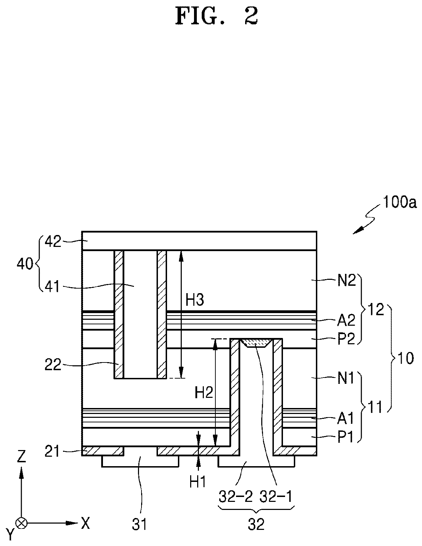

FIG. 2 is a diagram illustrating a light-emitting device 100a according to one or more other embodiments. Upon comparing FIG. 1 with FIG. 2, the shape of the first p-type contact layer 32-1 included in the light-emitting device 100a of FIG. 2 is different from the shape of the first p-type contact layer 32-1 included in the light-emitting device 100 of FIG. 1. A cross-sectional shape of the first p-type contact layer 32-1 shown in FIG. 2 in a vertical direction (Z direction, or a thickness direction of the light-emitting structure) of the light-emitting device 100a may be a trapezoid. For example, a surface of the first p-type contact layer 32-1 may include an r-plane surface and a c-plane surface. When the first p-type contact layer 32-1 is grown on the p-type semiconductor layer P2 of the second light-emitting element 12, the cross-sectional shape of the first p-type contact layer 32-1 may vary according to growth temperature, pressure, etc. In addition, the cross-sectional shape of the first p-type contact layer 32-1 in the vertical direction (Z direction, or a thickness direction of the light-emitting structure) of the light-emitting device 100a may include a part of, for example, a circle, a part of an ellipse, or a part of a polygon.

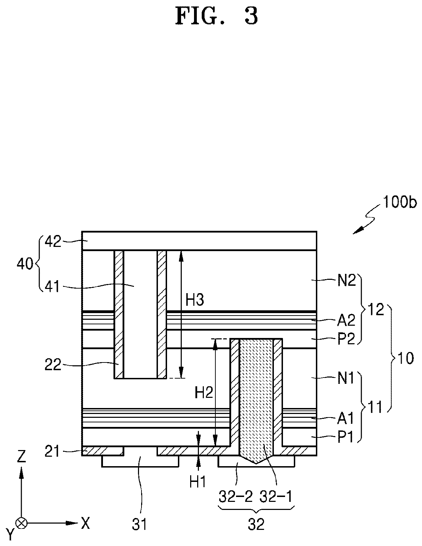

FIG. 3 is a diagram illustrating a light-emitting device 100b according to one or more other embodiments. Upon comparing FIG. 1 with FIG. 3, the first p-type contact layer 32-1 included in the light-emitting device 100b of FIG. 3 may fill the second hole H2 to a surface of the first light-emitting element 11. In addition, the first conductive layer 32-2 may be in contact with the first p-type contact layer 32-1 outside the second hole H2. The filling ratio of the first p-type contact layer 32-1 in the hole H2 may vary depending on the degree of damage to the p-type semiconductor layer P2 of the second light-emitting element 12.

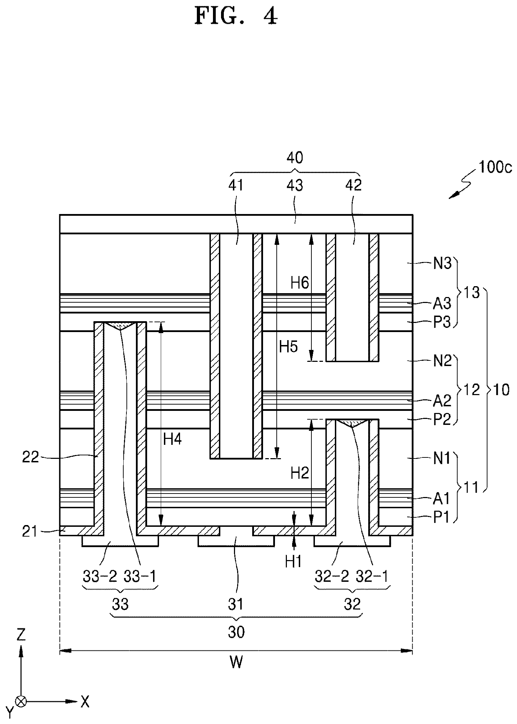

FIG. 4 is a diagram illustrating a light-emitting device 100c including the first light-emitting element 11, the second light-emitting element 12, and a third light-emitting element 13 according to one or more embodiments.

The light-emitting device 100c according to one or more embodiments may include the light-emitting structure 10 in which the first light-emitting element 11, the second light-emitting element 12, and the third light-emitting element 13 emitting light of different wavelengths are monolithically stacked. The light-emitting structure 10 may be a structure in which the first light-emitting element 11 emitting light of a first wavelength, the second light-emitting element 12 emitting light of a second wavelength different from the first wavelength, and the third light-emitting element 13 emitting light of a third wavelength different from the first wavelength and the second wavelength are stacked in the vertical direction (Z direction, or a thickness direction of the light-emitting structure) of the light-emitting structure 10. For example, the first light-emitting element 11 may emit red light, the second light-emitting element 12 may emit green light, and the third light-emitting element 13 may emit blue light. As will be described below, the light-emitting structure 10 may be formed by sequentially and monolithically growing the third light-emitting element 13, the second light-emitting element 12, and the first light-emitting element 11 on one sacrificial layer. Thus, the light-emitting structure 10 may not include a bonding material for coupling the first light-emitting element 11, the second light-emitting element 12, and the third light-emitting element 13.

The first light-emitting element 11 may include the p-type semiconductor layer P1, the active layer A1 disposed on the p-type semiconductor layer P1, and the n-type semiconductor layer N1 disposed on the active layer A1. The second light-emitting element 12 may include the p-type semiconductor layer P2 disposed on the n-type semiconductor layer N2 of the first light-emitting element 11, the active layer A2 disposed on the p-type semiconductor layer P2, and the n-type semiconductor layer N2 disposed on the active layer A2. The third light-emitting element 13 may include a p-type semiconductor layer P3 disposed on the n-type semiconductor layer N2 of the second light-emitting element 12, an active layer A3 disposed on the p-type semiconductor layer P3, and an n-type semiconductor layer N3 disposed on the active layer A3.

Light of a shorter wavelength may be emitted from the first light-emitting element 11 to the third light-emitting element 13. For example, a wavelength of light emitted by the first-light emitting element 11 may be greater than a wavelength of light emitted by the second-light emitting element 12, and the wavelength of light emitted by the second-light emitting element 12 may be greater than a wavelength of light emitted by the third-light emitting element 13. For example, the active layer A1 of the first light-emitting element 11 may include an indium content of about 35 at% to emit red light, the active layer A2 of the second light-emitting element 12 may include an indium content of about 25 at% to emit green light, and the active layer A3 of the third light-emitting element 13 may include an indium content of about 15 at% to emit blue light.

In the light-emitting structure 10, the first light-emitting element 11, the second light-emitting element 12, and the third light-emitting element 13 are sequentially arranged in a vertical direction (Z direction, or a thickness direction of the light-emitting structure), so that a lower surface of the first insulating layer 21 may be a lower surface of the light-emitting structure 10, and an upper surface of the third light-emitting element 13 may be an upper surface of the light-emitting structure 10.

The light-emitting device 100c according to one or more embodiments may further include one or more holes penetrating a partial area of the light-emitting structure 10. For example, the first hole H1 penetrating the first insulating layer 21 from the lower surface of the light-emitting structure 10 to expose the p-type semiconductor layer P1 of the first light-emitting element 11, the second hole H2 penetrating the first insulating layer 21 and the first light-emitting element 11 from the lower surface of the light-emitting structure 10 to expose the p-type semiconductor layer P2 of the second light-emitting element 12, a fourth hole H4 penetrating the first insulating layer 21, the first light-emitting element 11, and the second light-emitting element 12 from the lower surface of the light-emitting structure 10 to expose the p-type semiconductor layer P3 of the third light-emitting element 13, a fifth hole H5 penetrating the third light-emitting element 13 and the second light-emitting element 12 from an upper surface of the light-emitting structure 10 (an upper surface of the third light-emitting element 13) to expose the n-type semiconductor layer N1 of the first light-emitting element 11, and a sixth hole H6 penetrating the third light-emitting element 13 from the upper surface of the light-emitting structure 10 to expose the n-type semiconductor layer N2 of the second light-emitting element 12 may be disposed in the light-emitting structure 10. The first hole H1, the second hole H2, the fourth hole H4, the fifth hole H5, and the sixth hole H6 may be spatially spaced apart from each other.

The active area of the light-emitting structure 10 decreases by the widths of the first hole H1, the second hole H2, the fourth hole H4, the fifth hole H5, and the sixth hole H6, and thus, the widths of the first hole H1, the second hole H2, the fourth hole H3, the fourth hole H4, the fifth hole H5, and the sixth hole H6 in the horizontal direction (X-direction and/or Y-direction, or a direction perpendicular to a thickness direction of the light-emitting structure) may be relatively small. The width of each of the first hole H1, the second hole H2, the fourth hole H3, the fourth hole H4, the fifth hole H5, and the sixth hole H6 in the horizontal direction (X-direction and/or Y-direction, or a direction perpendicular to a thickness direction of the light-emitting structure)may be equal to or less than 1/5 of the width of the light-emitting structure 10. For example, the width of each of the first hole H1, the second hole H2, the fourth hole H3, the fourth hole H4, the fifth hole H5, and the sixth hole H6 may be less than or equal to about 1 µm and less than or equal to about 0.5 µm.

The light-emitting device 100c according to one or more embodiments may further include the second insulating layer 22 provided on surrounding side surfaces of holes formed inside the light-emitting structure 10, that is, the second to fifth holes H2, H3, H4, and H5.

The light-emitting device 100c according to one or more embodiments may further include the first electrode pattern 30 exposed on the lower surface of the light-emitting structure 10 (i.e., the lower surface of the first light-emitting element 11) while being electrically connected to the p-type semiconductor layers P1, P2, and P3 of the light-emitting structure 10 and the second electrode pattern 40 exposed on the upper surface of the light-emitting structure 10 (i.e., the upper surface of the third light-emitting element 13 or an upper surface of the n-type semiconductor layer N3 of the third light-emitting element 13) while being electrically connected to the n-type semiconductor layers N1, N2, and N3 of the light-emitting structure 10.

The first light-emitting element 11, the second light-emitting element 12, and the third light-emitting element 13 may receive a common voltage through one of the first electrode pattern 30 and the second electrode pattern 40, and may receive an independent driving voltage through the other one of the first electrode pattern 30 and the second electrode pattern 40.

The first electrode pattern 30 may include the first electrode 31 electrically and/or physically connected to the p-type semiconductor layer P1 of the first light-emitting element 11, the second electrode 32 electrically and/or physically connected to the p-type semiconductor layer P2 of the second light-emitting element 12, and a fifth electrode 33 electrically and/or physically connected to the p-type semiconductor layer P3 of the third light-emitting element 13. Detailed descriptions of the first electrode 31 and the second electrode 32 shown in FIG. 4 respectively corresponding to the first electrode 31 and the second electrode 32 described with reference to FIG. 1 will be omitted.

The fifth electrode 33 may penetrate the first light-emitting element 11 and the second light-emitting element 12 to be in contact with the p-type semiconductor layer P3 of the third light-emitting element 13. The fifth electrode 33 may also include a second p-type contact layer 33-1 in contact with the p-type semiconductor layer P3 of the third light-emitting element 13 and a second conductive layer 33-2 in contact with the second p-type contact layer 33-1 and disposed in the fourth hole H4 including the second insulating layer 22, that is, a fourth insulating hole. The second p-type contact layer 33-1 and the second conductive layer 33-2 of the fifth electrode 33 may respectively correspond to the first p-type contact layer 32-1 and the first conductive layer 32-2 of the second electrode 32 shown in FIGS. 1 to 3, and thus detailed descriptions thereof will be omitted.

The second electrode pattern 40 may include the third electrode 41 electrically and/or physically connected to the n-type semiconductor layer N1 of the first light-emitting element 11, the fourth electrode 42 electrically and/or physically connected to the n-type semiconductor layer N2 of the second light-emitting element 12, and a sixth electrode 43 electrically and/or physically connected to the n-type semiconductor layer N3 of the third light-emitting element 13. Each of the third electrode 41 and the fourth electrode 42 may have a conductive via shape filling the fifth hole H5 and the sixth hole H6, and the sixth electrode 43 may have a conductive pad shape disposed in the n-type semiconductor layer N3 of the third light-emitting element 13.

The first light-emitting element 11 may emit red light based on an electrical signal applied through the first electrode 31 and the third electrode 41, the second light-emitting element 12 may emit green light based on an electrical signal applied through the second electrode 32 and the fourth electrode 42, and the third light-emitting element 13 may emit blue light based on an electrical signal applied through the fifth electrode 33 and the sixth electrode 43.

When the first electrode pattern 30 applies an independent driving voltage to each of the first light-emitting element 11, the second light-emitting element 12, and the third light-emitting element 13, the first electrode 31, the second electrode 32, and the fifth electrode 33 may not be connected to each other. When the second electrode pattern 40 applies a common voltage to the first light-emitting element 11, the second light-emitting element 12, and the third light-emitting element 13, the third electrode 41, the fourth electrode 42, and the sixth electrode 43 may be disposed to be connected to each other. For example, the sixth electrode 43 may be disposed on the upper surface of the light-emitting structure 10, that is, an upper surface of the n-type semiconductor layer N3 of the third light-emitting element 13, while being in contact with the third electrode 41 and the fourth electrode 42. However, embodiments are not limited thereto. Even when the second electrode pattern 40 applies a common voltage to the first light-emitting element 11, the second light-emitting element 12, and the third light-emitting element 13, at least one of the third electrode 41, the fourth electrode 42, or the sixth electrode 43 may not be connected to each other.

It has been described above that the first light-emitting element 11 emits red light, the second light-emitting element 12 emits green light, and the third light-emitting element 13 emits blue light. For example, it has been described above that the first light-emitting element 11 emits light of a wavelength longer than a wavelength of the second light-emitting element 12, and the third light-emitting element 13 emits light of a wavelength shorter than the wavelength of the second light-emitting element 12. However, embodiments are not limited thereto. The first light-emitting element 11 may emit light of a wavelength shorter than the wavelength of the second light-emitting element 12, or the third light-emitting element 13 may emit light of a wavelength longer than the wavelength of the second light-emitting element 12, and the wavelength of light emitted by the first light-emitting element 11, the second light-emitting element 12, and the third light-emitting element 13 may be determined according to materials of the active layers A1, A2, and A3.

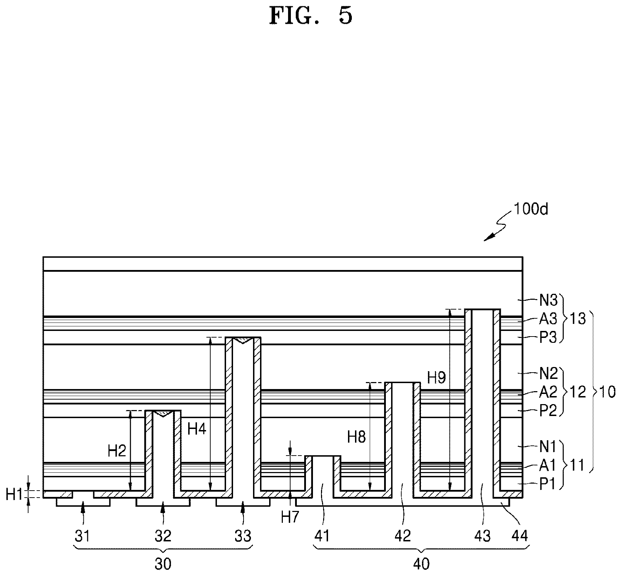

FIG. 5 is a diagram illustrating a light-emitting device 100d including electrode patterns disposed on the same surface of a light-emitting structure according to one or more embodiments.

Upon comparing FIG. 4 with FIG. 5, the second electrode pattern 40 of FIG. 5 may be exposed on a lower surface of the light-emitting structure 10 (i.e., a lower surface of the first insulating layer 21) while being electrically and/or physically connected to the n-type semiconductor layers N1, N2, and N3 of the light-emitting structure 10. For example, the second electrode pattern 40 may include the third electrode 41 penetrating the first insulating layer 21, the p-type semiconductor layer P1 of the first light-emitting element 11, and the active layer A1 of the first light-emitting element 11 to be in contact with the n-type semiconductor layer N1 of the first light-emitting element 11, the fourth electrode 42 penetrating the first insulating layer 21, the first light-emitting element 11, the p-type semiconductor layer P2 of the second light-emitting element 12, and the active layer A2 of the second light-emitting element 12 to be in contact with the n-type semiconductor layer N2 of the second light-emitting element 12, and the sixth electrode 43 penetrating the first insulating layer 21, the first light-emitting element 11, the second light-emitting element 12, the p-type semiconductor layer P3 of the third light-emitting element 13, and the active layer A3 of the third light-emitting element 13 to be in contact with the n-type semiconductor layer N3 of the third light-emitting element 13. In addition, the second electrode pattern 40 may further include a seventh electrode 44 disposed on the first insulating layer 21 while being in contact with the third electrode 41, the fourth electrode 42, and the sixth electrode 43.

In the light-emitting device 100d shown in FIG. 5, the first hole H1, the second hole H2, the fourth hole H4, a seventh hole H7, an eighth hole H8, and a ninth hole H9 may be formed in the light-emitting structure 10 through a single plasma etching process, thereby simplifying the process.

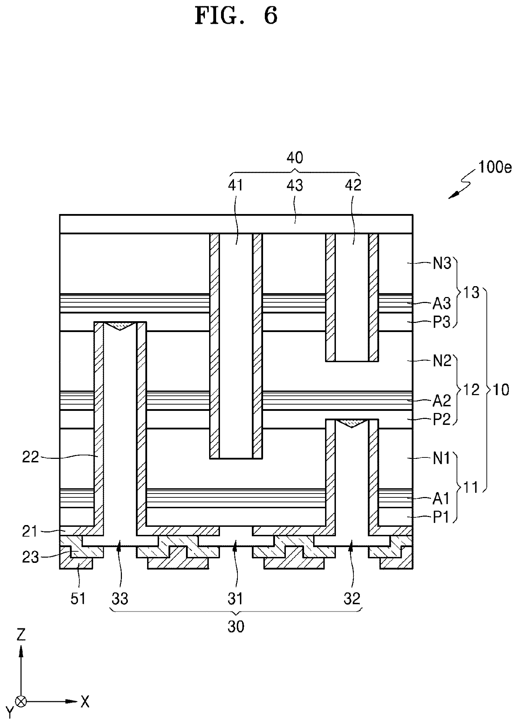

FIG. 6 is a diagram illustrating a light-emitting device 100e including a first reflective layer 51 according to one or more embodiments. Upon comparing FIG. 4 with FIG. 6, the light-emitting device 100e of FIG. 6 may further include a third insulating layer 23 disposed on the first insulating layer 21 and the first electrode pattern 30, and the first reflective layer 51 disposed on the third insulating layer 23 in a lower surface of the light-emitting structure 10. The third insulating layer 23 and the first reflective layer 51 may include holes overlapping the first hole H1, the second hole H2, and the fourth hole H4 in a vertical direction (Z direction, or a thickness direction of the light-emitting structure) of the light-emitting structure 10. Thus, the first electrode 31, the second electrode 32, and the fifth electrode 33 of the first electrode pattern 30 may be exposed to the outside by the holes of the third insulating layer 23 and the first reflective layer 51. Similar to the first insulating layer 21, the third insulating layer 23 may include a transparent insulating material.

The first reflective layer 51 may reflect incident light into the light-emitting structure 10. The first reflective layer 51 may reflect the incident light into the light-emitting structure 10 and emit the incident light to the outside through an upper surface of the light-emitting structure 10, thereby increasing the light emission efficiency emitted to the upper surface of the light-emitting structure 10. The first reflective layer 51 may include a material of high reflectivity with respect to light. The first reflective layer 51 may include a metal material, for example, Ag, Au, Pt, Ni, Cr, and/or Al, but is not limited thereto. When an area of the first electrode pattern 30 protruding from the lower surface of the light-emitting structure 10 includes a metal of relatively high reflectivity, light emitted to the lower surface of the light-emitting structure 10 may be more effectively reduced.

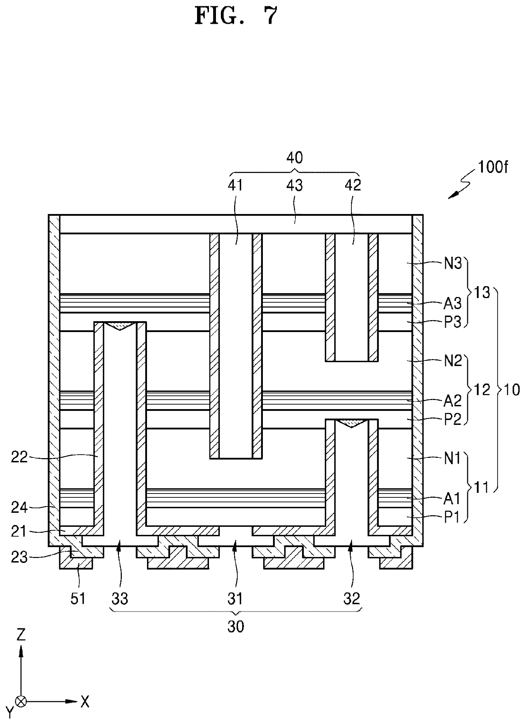

FIG. 7 is a diagram illustrating a light-emitting device 100f including a fourth insulating layer 24 according to one or more embodiments. Upon comparing FIG. 6 with FIG. 7, the light-emitting device 100f of FIG. 7 may further include the fourth insulating layer 24 provided on and surrounding a side surface of the light-emitting structure 10. The fourth insulating layer 24 may be a protective layer protecting the light-emitting structure 10 from the outside. Similar to the first insulating layer 21, the fourth insulating layer 24 may include a transparent insulating material. However, embodiments are not limited thereto. The fourth insulating layer 24 may be a black matrix material. Thus, the fourth insulating layer 24 may prevent light generated by the light-emitting structure 10 from being emitted to the side surface of the light-emitting structure 10 or prevent light from being incident on the side surface of the light-emitting structure 10 from the outside.

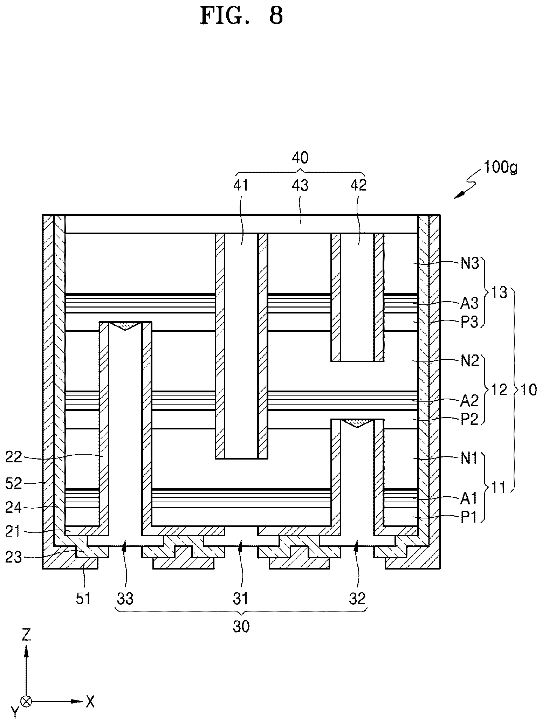

FIG. 8 is a diagram illustrating a light-emitting device 100g including a second reflective layer 52 according to one or more embodiments. Upon comparing FIG. 7 with FIG. 8, the light-emitting device 100g of FIG. 8 may further include the second reflective layer 52 provided on and surrounding a side surface of the light-emitting structure 10. The second reflective layer 52 may be disposed on the fourth insulating layer 24. The second reflective layer 52 may reflect light traveling to the side surface of the light-emitting structure 10 into the inside of the light-emitting structure 10. Thus, the light generated by the light-emitting structure 10 may be emitted to the outside through an upper surface of the light-emitting structure 10, thereby increasing the light emission efficiency in a direction of the upper surface of the light-emitting structure 10.

The light-emitting devices 100c, 100d, 100f, and 100g according to one or more embodiments may emit light of a plurality of different wavelengths and accordingly be used as pixels of a display apparatus. The one light-emitting device 100 becomes one pixel, and thus a relatively small and high-resolution display apparatus may be implemented. The light-emitting devices 100, 100a, and 100b according to one or more embodiments may also be used as pixels of a display apparatus. When the light-emitting devices 100, 100a, and 100b according to one or more embodiments are used as pixels of a display apparatus, a combination of a plurality of light-emitting devices may be one pixel. The light-emitting devices 100, 100a, 100b, 100c, 100d, 100f, or 100g may be implemented as monolithic light emitters that include stacked red/green/blue (R/G/B) light sources with n-type and p-type semiconductor electrodes configured on the R/G/B light sources. During electrode formation, a via hole etching process may damage the p-type semiconductor electrode. To recover from this damage, a p-type contact layer (e.g., a first p-type contact layer 32-1) may be selectively regrown in the damaged areas. This process of regrowing the p-type contact layer may help prevent any degradation in the device's characteristics. In one example, the regrown p-type contact layer may take a truncated shape or may fill the via hole, depending on the growth conditions. The regrown p-type contact layer restores the damaged p-type semiconductor electrode exposed during the via hole etching process, preventing any degradation of electrical properties. This structure ensures stable electrical performance and eliminates the damage typically caused by the etching process.

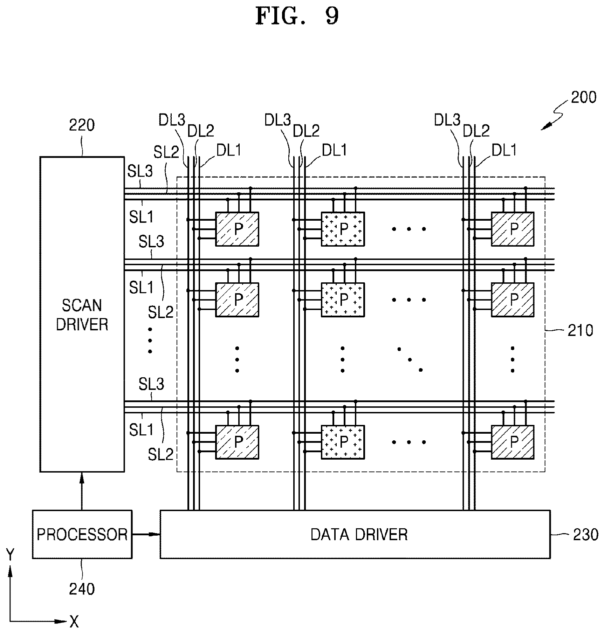

FIG. 9 is a block diagram of a display apparatus 200 including a light-emitting device according to one or more embodiments. Referring to FIG. 9, the display apparatus 200 may include a pixel array 210, a scan driver 220, a data driver 230, and a processor 240. The pixel array 210 may include a plurality of pixels P arranged in a two-dimensional (2D) array form, a plurality of scan line sets transmitting scan signals to the plurality of pixels P, and a plurality of data line sets transmitting data signals to the plurality of pixels P.

At least one of the plurality of pixels P of the pixel array 210 may include the light-emitting device 100a, 100b, 100c, 100c, 100d, 100f, and 100g described above. Hereinafter, for convenience of description, a light-emitting device emitting light of three different wavelengths will be mainly described. For example, at least one of the plurality of pixels P may include the one light-emitting device 100a, 100b, 100c, 100d, 100f, or 100g, including the first light-emitting element 11 emitting red light, the second light-emitting element 12 emitting green light, and the third light-emitting element 13 emitting blue light, and a first transistor TR1, a second transistor TR2, and a third transistor TR3 electrically connected to the first light-emitting element 11, the second light-emitting element 12, and the third light-emitting element 13, respectively.

Each of scan line sets may include a first scan line SL1, a second scan line SL2, and a third scan line SL3 extending in the X direction. The first scan line SL1, the second scan line SL2, and the third scan line SL3 may be respectively connected to the plurality of pixels P arranged in the X direction. For example, the first scan line SL1 may be electrically connected to a gate electrode G of the first transistor TR1 in each of the plurality of pixels P, the second scan line SL2 may be electrically connected to the gate electrode G of the second transistor TR2 in each of the pixels P, and the third scan line SL3 may be electrically connected to the gate electrode G of the third transistor TR3 in each of the pixels P. The first scan line SL1, the second scan line SL2, and the third scan line SL3 may also be connected to the scan driver 220 to receive scan signals from the scan driver 220.

Each of data line sets may include a first data line DL1, a second data line DL2, and a third data line DL3 extending in the Y direction. The first data line DL1, the second data line DL2, and the third data line DL3 may be respectively connected to the plurality of pixels P arranged in the Y direction. For example, the first data line DL1 may be electrically connected to a source horizontal line SHL of the first transistor TR1 in each of the pixels P, the second data line DL2 may be electrically connected to the source horizontal line SHL of the second transistor TR2 in each of the pixels P, and the third data line DL3 may be electrically connected to the source horizontal line SHL of the third transistor TR3 in each of the pixels P. The first data line DL1, the second data line DL2, and the third data line DL3 may also be connected to the data driver 230 to receive data signals from the data driver 230.

The processor 240 may control operations of the scan driver 220 and the data driver 230 based on data of images to be displayed by the pixel array 210, thereby adjusting the scan signal and the data signal provided to each of the pixels P.

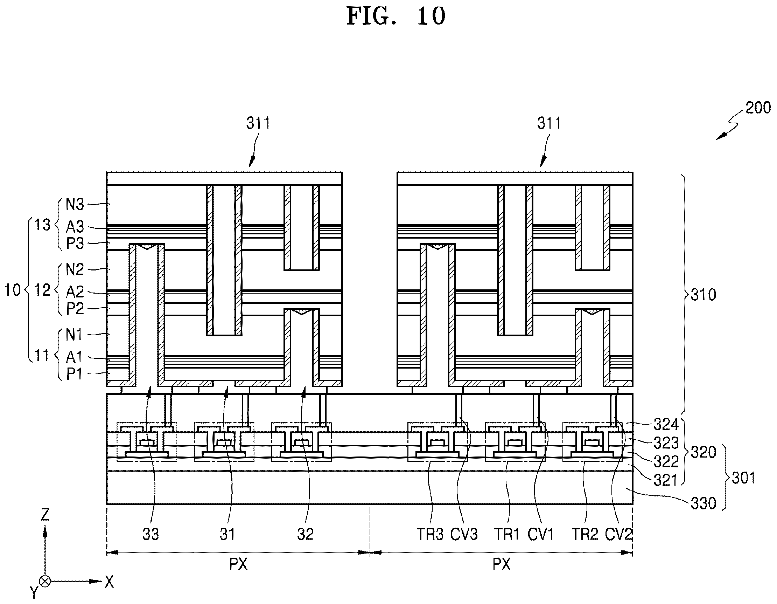

FIG. 10 is a diagram illustrating a portion of the display apparatus 200 including a plurality of light-emitting devices 311according to one or more embodiments. Referring to FIG. 10, the display apparatus 200 may include a display layer 310 including the plurality of light-emitting devices 311, a driving layer 320 driving the plurality of light-emitting devices 311, and a substrate 330 supporting the driving layer 320. The driving layer 320 and the substrate 330 are collectively referred to as a backplane 301.

The display layer 310 may include the plurality of light-emitting devices 311. At least one of the plurality of light-emitting devices 311 may include the first light-emitting element 11, the second light-emitting element 12, and the third light-emitting element 13 which emit light of different wavelengths. From the perspective of the display apparatus 200, the first light-emitting element 11 may be a component of a first sub-pixel, the second light-emitting element 12 may be a component of a second sub-pixel, and the third light-emitting element 13 may be a component of a third sub-pixel. The light-emitting element 311 has been described above, and thus a detailed description thereof will be omitted. The light-emitting device 100b shown in FIG. 4 is shown in FIG. 10, but embodiments are not limited thereto.

The substrate 330 may include an insulating material such as, for example, glass, an organic polymer, crystal, etc. In addition, the substrate 330 may include a material of flexibility to be bent or folded, and may have a single-layer structure or a multi-layer structure.

The driving layer 320 may include a buffer layer 321 disposed on the substrate 330 and a transistor TFT disposed on the buffer layer 321. The driving layer 320 may further include a driving voltage wiring, the scan driver 220, the data driver 230, and the processor 240, which are not shown in FIG. 10.

The buffer layer 321 may prevent diffusion of impurities into the transistor TFT. The buffer layer 321 may be provided as a single layer, but may be provided as at least a double layer or multiple layers.

When the buffer layer 321 is provided as multiple layers, the multiple layers may include the same material or may include different materials. The buffer layer 321 may be omitted according to a material and process conditions of the substrate 330.

The first to third transistors TR1, TR2, and TR3 may drive corresponding light-emitting elements included in the display layer 310. For example, the driving layer 320 may include the first transistor TR1 driving the first light-emitting element 11, the second transistor TR2 driving the second light-emitting element 12, and the third transistor TR3 driving the third light-emitting element 13. Each of the first to third transistors TR1, TR2, and TR3 may include a semiconductor layer SC, a gate electrode G, a source electrode S, and a drain electrode D.

The semiconductor layer SC may be disposed on the buffer layer 321. The semiconductor layer SC may include a source area in contact with the source electrode S and a drain area in contact with the drain electrode D. An area between the source area and the drain area may be a channel area.

The semiconductor layer SC may be a semiconductor pattern including polysilicon, amorphous silicon, oxide semiconductor, etc. The channel area is a semiconductor pattern that is not doped with impurities, and may be an intrinsic semiconductor. The source area and the drain area may be semiconductor patterns doped with impurities.

The gate electrode G may be provided on the semiconductor layer SC with the gate insulating layer 322 disposed the gate electrode G and the semiconductor layer SC.

Each of the source electrode S and the drain electrode D may be in contact with the source area and the drain area of the semiconductor layer SC through a contact hole penetrating an interlayer insulating layer 323 and a gate insulating layer 322.

A protection layer 324 may be provided on the first to third transistors TR1, TR2, and TR3. The protective layer 324 may include first to third conductive vias CV1, CV2, and CV3. The first electrode 31 may be electrically connected to the first transistor TR1 (e.g., drain of the first transistor TR1) through the first conductive via CV1, the second electrode 32 may be electrically connected to the second transistor TR2 (e.g., drain of the second transistor TR2) through the second conductive via CV2, and the fifth electrode 33 may be electrically connected to the third transistor TR3 (e.g., drain of the third transistor TR3) through the third conductive via CV3. Although not shown in FIG. 10, the second electrode pattern 40 may also be connected to a circuit module of the driving layer 320 through a wiring.

When a driving voltage is applied through the first electrode pattern 30 and a common voltage is applied through the second electrode pattern 40, each of the first light-emitting element 11, the second light-emitting element 12, and the third light-emitting element 13 may independently emit light based on the applied voltage.

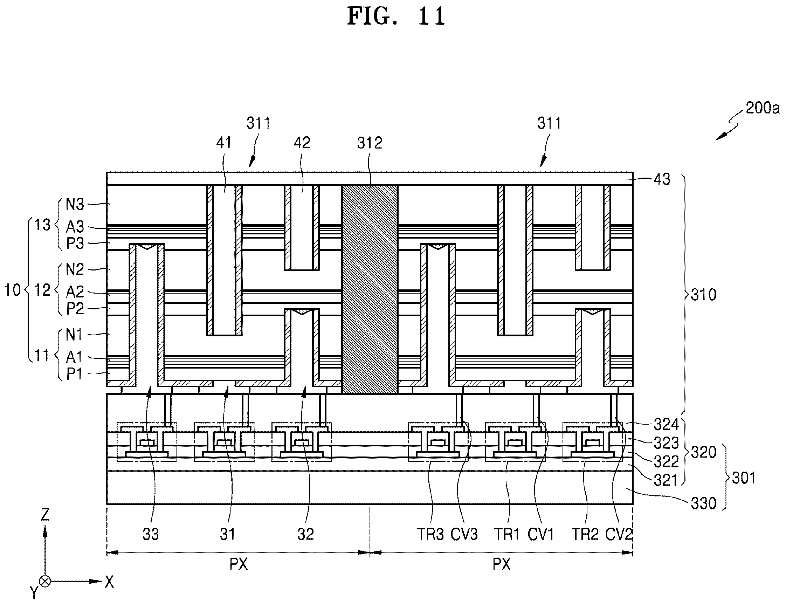

FIG. 11 is a diagram illustrating a display apparatus 200a including a pixel partition 312 according to one or more embodiments.

Referring to FIGS. 10 and 11, the display apparatus 200a of FIG. 11 may further include the pixel partition 312 disposed between the light-emitting devices 311. The pixel partition 312 may improve contrast by preventing mixing between lights emitted from the light-emitting devices 311. The pixel partition 312 may include at least one of, for example, a black matrix material, a resin, or a polymer.

The sixth electrodes 43 included in the neighboring and adjacent light-emitting devices 311 may extend to an upper surface of the pixel partition 312 to be connected to each other. For example, the sixth electrodes 43 included in the neighboring and adjacent light-emitting devices 311 may be disposed on the same plane. The sixth electrodes 43 included in the plurality of light-emitting devices 311 are connected to each other, and thus the number of circuit modules applying a common voltage may be reduced.

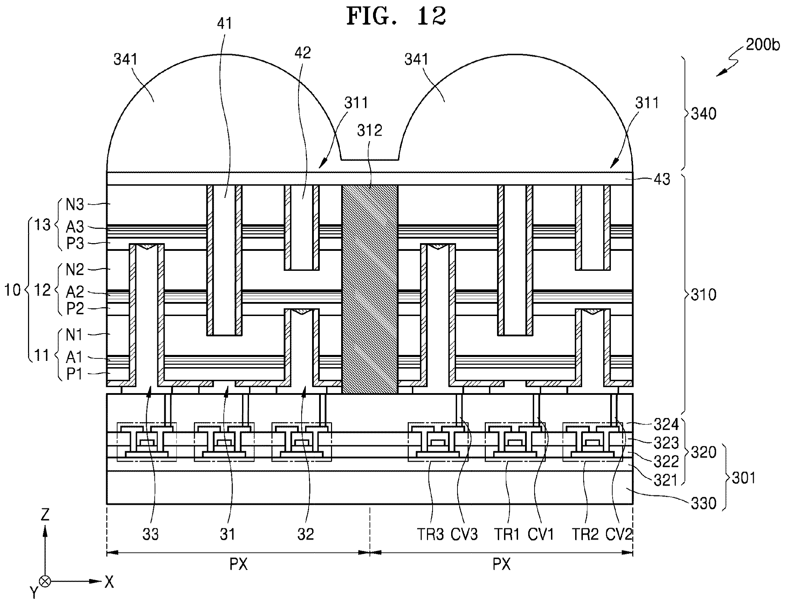

FIG. 12 is a diagram illustrating a display apparatus 200b including an optical layer 340 controlling an optical path according to one or more embodiments.

Referring to FIGS. 11 and 12, the display apparatus 200b of FIG. 12 may include the optical layer 340 disposed on the display layer 310 and may control a traveling path of light emitted from the display layer 310. The optical layer 340 may include a plurality of microlenses 341 disposed to correspond to the plurality of light-emitting devices 311 on a one-to-one basis. Each of the microlenses 341 may guide along a specific direction by adjusting a traveling path of light emitted to the corresponding light-emitting element 311. The microlenses 341 may have different refractive indexes and thus focus light emitted from the display layer 310. Accordingly, the display apparatus 200b may generate an image of a relatively small viewing angle. The optical layer 340 may enlarge or reduce an image generated in the display layer 310 according to the use of the display apparatus 200b. In addition, the optical layer 340 may prevent mixing of lights emitted from the adjacent light-emitting element 311.

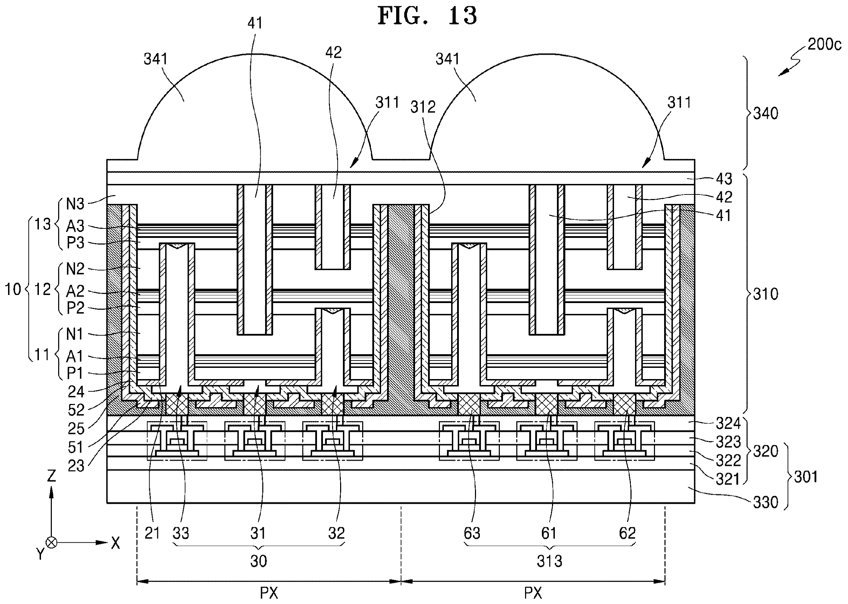

FIG. 13 is a diagram illustrating a display apparatus 200c to which the light-emitting devices 311 are connected according to one or more embodiments.

Referring to FIGS. 12 and 13, the n-type semiconductor layers N3 of the third light-emitting elements 13 may be connected to each other in the neighboring light-emitting devices 311 of the display apparatus 200c of FIG. 13. The pixels PX may be partitioned by the pixel partition 312 penetrating a partial area of the light-emitting structure 10. The pixel partition 312 may be a trench penetrating the p-type semiconductor layers P3 of the first light-emitting element 11, the second light-emitting element 12, and the third light-emitting element 13, and the active layer A3 of the third light-emitting element 13. The trench may form a closed loop, and the shape of the closed loop may be a cross-sectional shape of the pixel PX. For example, from the perspective of vertical direction (Z direction, or a thickness direction of the light-emitting structure) of the display layer 310, the cross-sectional shape of the pixel partition 312 may be a polygon, for example, a square. When the cross-sectional shape of the pixel partition 312 is a polygon, the display apparatus 200c of a higher resolution per unit area may be implemented compared to a circular or elliptical cross-sectional shape. A width of the pixel partition 312 may be determined by a distance between the pixels PX. The fourth insulating layer 24 and the second reflective layer 52 may be sequentially disposed on a side surface of the pixel partition 312.

The display layer 320 may further include a contact electrode pattern 313 electrically connecting the first electrode 31, the second electrode 32, and the fifth electrode 33 to the driving layer 320. The contact electrode pattern 313 may include a first contact electrode 61 electrically connecting the first electrode 31 to the driving layer 320, a second contact electrode 62 electrically connecting the second electrode 32 to the driving layer 320, and a third contact electrode 63 electrically connecting the fifth electrode 33 to the driving layer 320. The contact electrode pattern 313 may include a conductive material. For example, the contact electrode pattern 313 may be a bonding metal such as Au, tin (Sn), or copper (Cu).

The display layer 310 may further include a fifth insulating layer 25 filling the remaining space of the pixel partition 312 and a space between the display layer 310 and the driving layer 320. The fifth insulating layer 25 may include at least one of a black matrix material, a resin, or a polymer. As another example, the fifth insulating layer 25 may include a transparent inorganic material such as SiO₂.

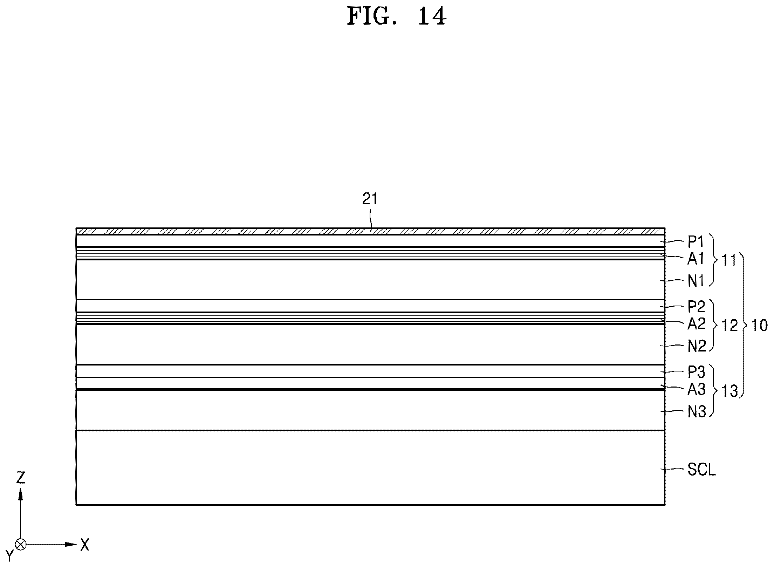

FIGS. 14 to 24 are reference diagrams for describing a method of manufacturing the display apparatus 200c according to one or more embodiments.

Referring to FIG. 14, the light-emitting structure 10 may be formed in a sacrificial layer SCL. The sacrificial layer SCL may be a layer for growing a light-emitting device. The sacrificial layer SCL may include various materials used in a general semiconductor process. For example, a silicon substrate or a sapphire substrate may be used as the sacrificial layer SCL.

The third light-emitting element 13, the second light-emitting element 12, and the first light-emitting element 11 may be sequentially and vertically formed on the sacrificial layer SCL. For example, the n-type semiconductor layer N3, the active layer A3, and the p-type semiconductor layer P3 of the third light-emitting element 13 may be sequentially grown on the sacrificial layer SCL, the n-type semiconductor layer N2, the active layer A2, and the p-type semiconductor layer P2 of the second light-emitting element 12 may be sequentially grown on the p-type semiconductor layer P3 of the third light-emitting element 13, and the n-type semiconductor layer N1, the active layer A1, and the p-type semiconductor layer P1 of the first light-emitting element 11 may be sequentially grown on the p-type semiconductor layer P2 of the second light-emitting element 12.

Among the first light-emitting element 11, the second light-emitting element 12, and the third light-emitting element 13, the lowest indium content may be included in the active layer A3 of the third light-emitting element 13, and the highest indium content may be included in the active layer A1 of the first light-emitting element 11. In general, the lower the indium content, the higher the growth temperature of the nitride semiconductor, and thus an active layer with a relatively high growth temperature may be grown first and an active layer with a relatively low growth temperature may be grown later. When an active layer having a lower indium content is first grown and an active layer having a higher indium content is subsequently grown, the active layer having the higher indium content may deteriorate. The growth order of the light-emitting structure 10 according to one or more embodiments may prevent deterioration of the active layer A1 of the first light-emitting element 11 having the highest indium content.

The light-emitting structure 10 according to one or more embodiments may not include a bonding material between the first light-emitting element 11, the second light-emitting element 12, and the third light-emitting element 13 because the third light-emitting element 13, the second light-emitting element 12, and the first light-emitting element 11 are sequentially and monolithically formed.

The light-emitting structure 10 may be formed using a method such as, for example, metal organic chemical vapor deposition (MOCVD), chemical vapor deposition (CVD), plasma-enhanced chemical vapor deposition (PECVD), molecular beam epitaxy (MBE), hydride vapor phase epitaxy (HVPE), etc.

The first insulating layer 21 may be further formed on the light-emitting structure 10, that is, the p-type semiconductor layer P1 of the first light-emitting element 11. The first insulating layer 21 may be formed through a CVD process.

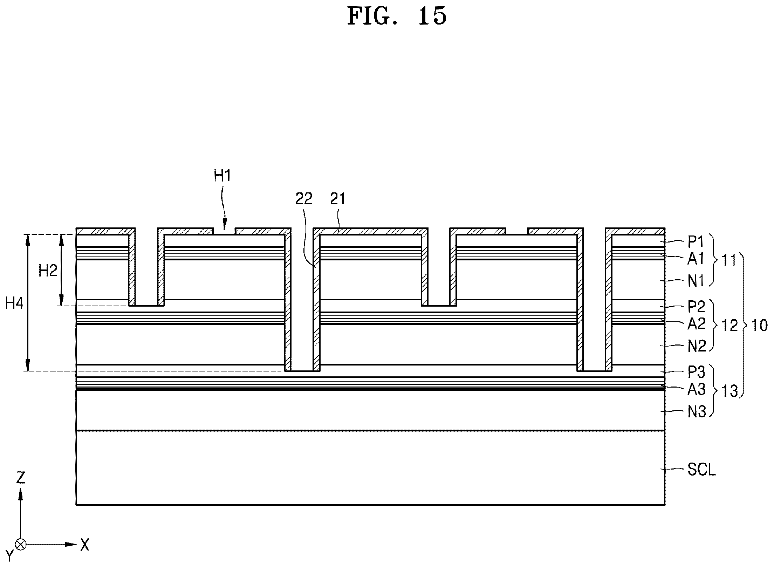

Referring to FIG. 15, the first hole H1 exposing the p-type semiconductor layer P1 of the first light-emitting element 11, the second hole H2 exposing the p-type semiconductor layer P2 of the second light-emitting element 12, and the fourth hole H4 exposing the p-type semiconductor layer P3 of the third light-emitting element 13 may be formed in the light-emitting structure 10, and the second insulating layer 22 provided on and surrounding side surfaces of the second hole H2 and the fourth hole H4 may be formed. The second hole H2 may penetrate the first light-emitting element 11, and the fourth hole H4 may penetrate the first light-emitting element 11 and the second light-emitting element 12, and thus the active areas of the first light-emitting element 11, the second light-emitting element 12, and the third light-emitting element 13 may be reduced. Therefore, the widths of the second hole H2 and the fourth hole H4 may be small such as less than or equal to about 1 µm or less than or equal to about 0.5 µm in the horizontal direction (X-direction and/or Y-direction, or a direction perpendicular to a thickness direction of the light-emitting structure). The second hole H2 and the fourth hole H4 may be performed through, for example, a plasma etching process. Because the first hole H1 is formed by etching only the first insulating layer 21, an etching process other than the plasma etching process may be applied. For example, the first hole H1 may be formed through dry etching or wet etching.

The second insulating layer 22 may be formed through, for example, an atomic layer deposition process. Even though the first insulating layer 21 is provided and surrounds the side surfaces of the second hole H2 and the fourth hole H4, the p-type semiconductor layer P2 of the second light-emitting element 12 and the p-type semiconductor layer P3 of the third light-emitting element 13 may still be exposed to the outside.

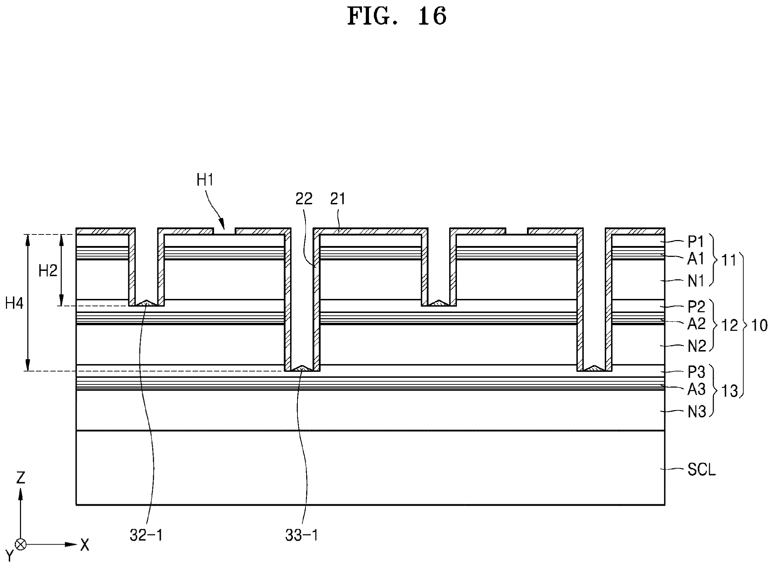

Referring to FIG. 16, the first p-type contact layers 32-1 may be formed on the p-type semiconductor layers P2 and P3 exposed to the outside, and thus the p-type semiconductor characteristics of the exposed p-type semiconductor layers P2 and P3 may be restored. As described above, the exposed p-type semiconductor layer P2 of the second light-emitting element 12 and the exposed p-type semiconductor layer P3 of the third light-emitting element 13 may be damaged in the process of forming the second hole H2 and the fourth hole H4 through the plasma etching process. Thus, the exposed p-type semiconductor layer P2 of the second light-emitting element 12 and the may be damaged p-type semiconductor layer P3 of the third light-emitting element 13 may lose diode junction characteristics or p-type semiconductor characteristics. The first p-type contact layer 32-1 and the second p-type contact layer 33-1 may be formed on the exposed p-type semiconductor layer P2 of the exposed second light-emitting element 12 and the exposed p-type semiconductor layer P3 of the third light-emitting element 13, and thus the lost p-type semiconductor characteristics may be restored.

The first p-type contact layer 32-1 and the second p-type contact layer 33-1 may be performed at a relatively high temperature, for example, greater than or equal to about 800 °C while the light-emitting structure 10 is disposed on the sacrificial layer SCL. For example, when the process of restoring the p-type semiconductor characteristics on a driving layer described below is performed, device characteristics of a transistor included in the driving layer may deteriorate.

The first p-type contact layer 32-1 and the second p-type contact layer 33-1 may be respectively in contact with the p-type semiconductor layer P2 of the second light-emitting element 12 and the p-type semiconductor layer P3 of the third light-emitting element 13 in the second hole H2 and the fourth hole H4 to be. The first p-type contact layer 32-1 and the second p-type contact layer 33-1 may include the same material as the p-type semiconductor layers P2 and P3, for example, a nitride semiconductor material, and may be doped with a p-type dopant. The content of the p-type dopant doped in the first p-type contact layer 32-1 may be greater than or equal to the content of a p-type dopant doped in the p-type semiconductor layer P2 of the second light-emitting element 12, and the content of the p-type dopant doped in the second p-type contact layer 33-1 may be greater than or equal to the content of a p-type dopant doped in the p-type semiconductor layer P3 of the third light-emitting element 13.

Each of the first p-type contact layer 32-1 and the second p-type contact layer 33-1 may adjust at least one of temperature or pressure and be grown to have a convex shape in the vertical direction (Z direction, or a thickness direction of the light-emitting structure) of the light-emitting structure 10. The cross-sectional shape of at least one of the first p-type contact layer 32-1 or the second p-type contact layer 33-1 in the vertical direction (Z direction, or a thickness direction of the light-emitting structure) of the light-emitting structure 10 may be a triangle. However, embodiments are not limited thereto, and the cross-sectional shape may be a trapezoid, a circle, or an ellipsoid.

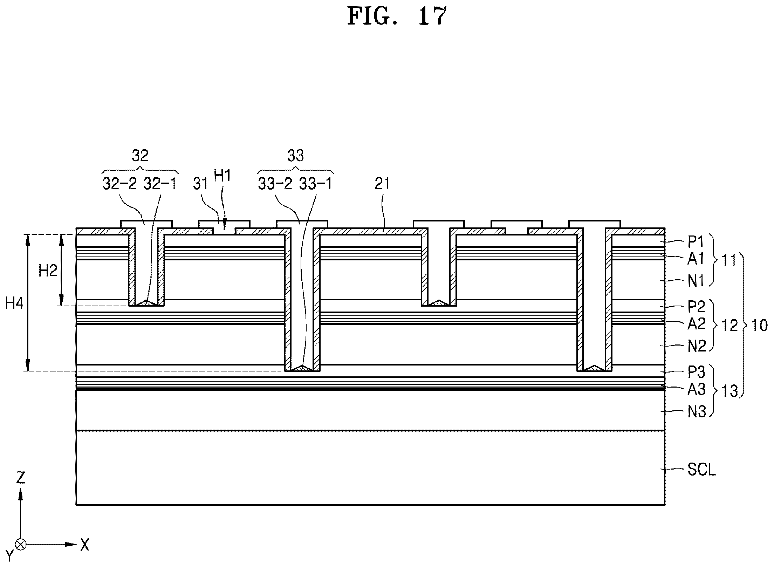

Referring to FIG. 17, the first electrode pattern 30 may be formed on the light-emitting structure 10. For example, the first electrode 31, the second electrode 32, and the fifth electrode 33 may be formed by forming the first electrode 31 on the p-type semiconductor layer P1 of the first light-emitting element 11 exposed through the first hole H1, the second conductive layer 33-2 on the first p-type contact layer 32-1 exposed through the second hole H2, and the second p-type contact layer 33-1 exposed through the fourth hole H4. The first electrode 31, the second electrode 32, and the fifth electrode 33 may all be exposed from the surface of the first light-emitting element 11 and extend onto the first insulating layer 21. The first electrode 31, the second electrode 32, and the fifth electrode 33 may be formed not to be connected to each other.

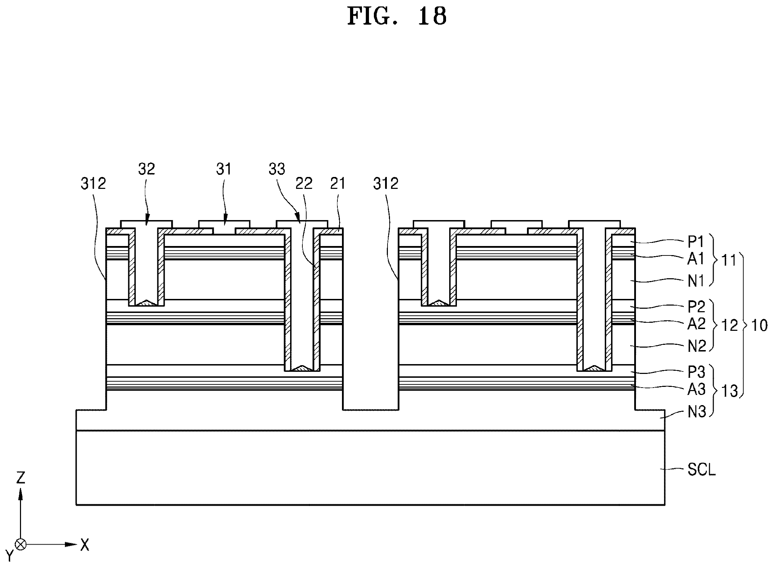

Referring to FIG. 18, the pixel partition 312 may be formed in the light-emitting structure 10. For example, the pixel partition 312 may be formed in a trench shape penetrating the p-type semiconductor layers P3 of the first light-emitting element 11, the second light-emitting element 12, and the third light-emitting element 13, and the active layer A1 of the third light-emitting element 11. The width of the pixel partition 312 may be a distance between the adjacent pixels PX. FIG. 18 illustrates that the pixel partition 312 does not penetrate the n-type semiconductor layer N3 of the third light-emitting element 13, but embodiments are not limited thereto. The pixel partition 312 may penetrate the n-type semiconductor layer N3 of the third light-emitting element 13. The pixel partition 312 does not penetrate the n-type semiconductor layer N3 of the third light-emitting element 13, thereby increasing the durability of the display layer 310.

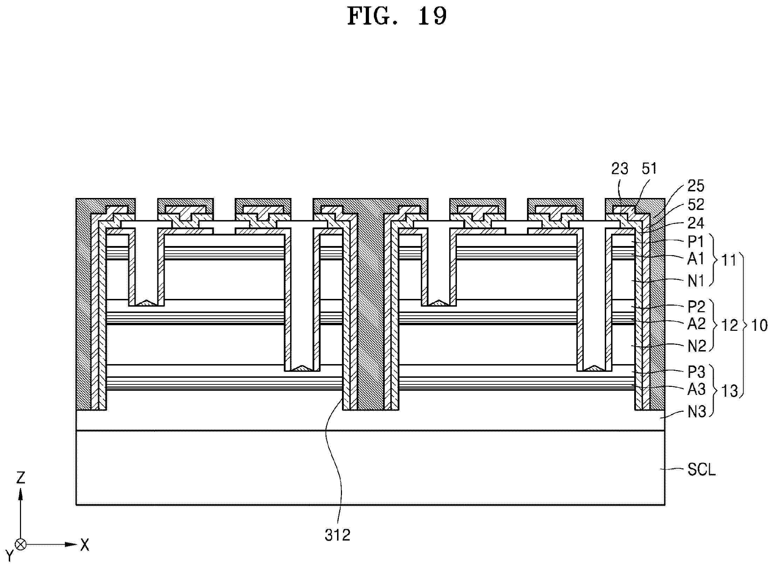

Referring to FIG. 19, the third insulating layer 23, the fourth insulating layer 24, the first reflective layer 51, the second reflective layer 52, and the fifth insulating layer 25 may be formed on the light-emitting structure 10. The third insulating layer 23 and the fourth insulating layer 24 may be respectively formed on the first electrode pattern 30 and a side surface of the pixel partition 312, and the first reflective layer 51 and the second reflective layer 25 may be respectively formed on the third insulating layer 23 and the fourth insulating layer 24. The third insulating layer 23 and the first reflective layer 51 may include holes exposing the first electrode 31, the second electrode 32, and the fifth electrode 33. The fifth insulating layer 25 may be formed to cover the entire first reflective layer 51 and filling a space in which the pixel partition 312 remains. The fifth insulating layer 25 may also include holes exposing the first electrode 31, the second electrode 32, and the fifth electrode 33. The third insulating layer 23 and the fourth insulating layer 24 may each include a transparent insulating material, and the fifth insulating layer 25 may include an insulating material of elasticity. In addition, the first reflective layer 51 and the second reflective layer 52 may each include a metal, etc.

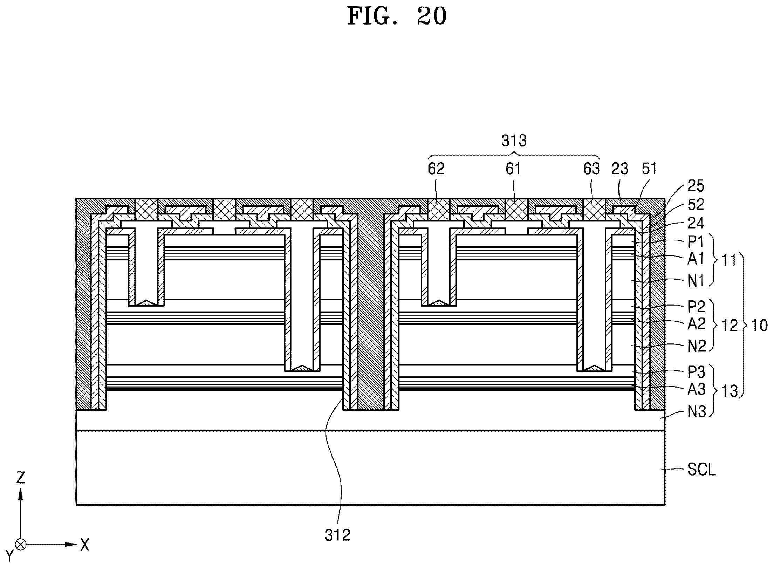

Referring to FIG. 20, the contact electrode pattern 313 including the first contact electrode 61, the second contact electrode 62, and the third contact electrode 63 which are in contact with the first electrode 31, the second electrode 32, and the fifth electrode 33 may be formed while filling the holes of the fifth insulating layers 25. The first contact electrode 61, the second contact electrode 62, and the third contact electrode 63 may each include a conductive material of elasticity.

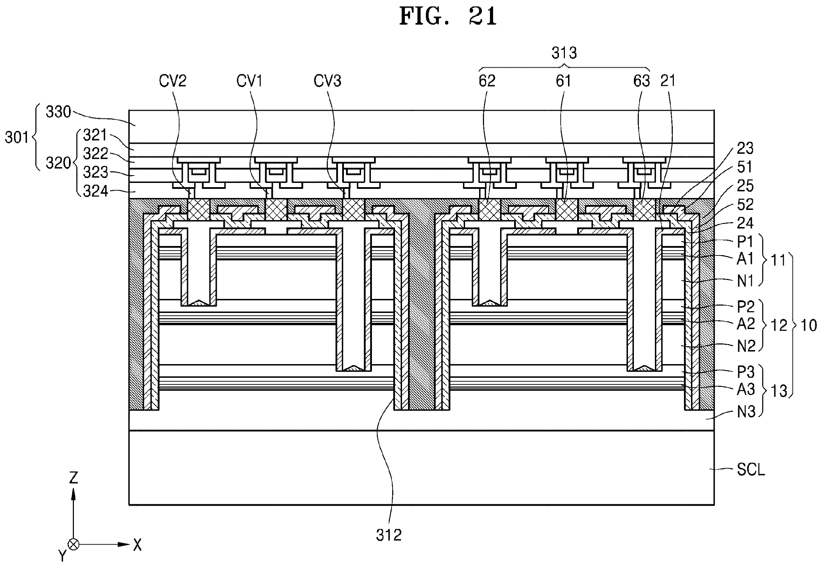

Referring to FIG. 21, the contact electrode pattern 313 may be bonded to the backplane 301. The backplane 301 may include the first transistor TR1, the second transistor TR2, and the third transistor TR3 respectively driving the first light-emitting element 11, the second light-emitting element 12, and the third light-emitting element 13. A first electrode pad, a second electrode pad, and a third electrode pad electrically connected to the first transistor TR1, the second transistor TR2, and the third transistor TR3 respectively are disposed on the surface of the backplane 301. The backplane 301 may be bonded to the light-emitting device 100c such that the first electrode pad, the second electrode pad, and the third electrode pad are connected to the first contact electrode 61, the second contact electrode 62, and the third contact electrode 63 on a one-to-one basis. The backplane 301 may include various types of circuit modules in addition to the first transistor TR1, the second transistor TR2, and the third transistor TR3.

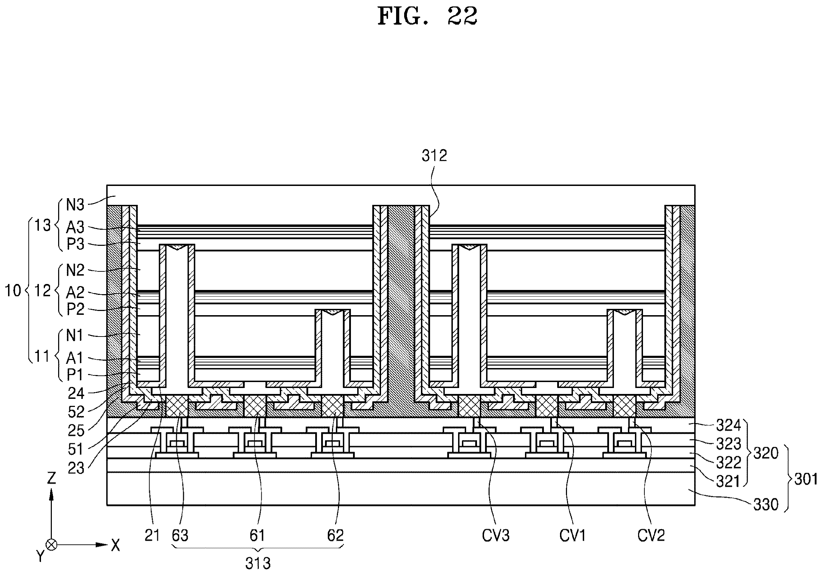

Referring to FIG. 22, the sacrificial layer SCL may be removed from the light-emitting structure 10. After bonding the light-emitting structure 10 and the backplane 301, a vertical direction (Z direction, or a thickness direction of the light-emitting structure) of the light-emitting structure 10 may be reversed so that the backplane 301 is disposed below the light-emitting structure 10. In addition, the sacrificial layer SCL may be removed from the light-emitting structure 10.

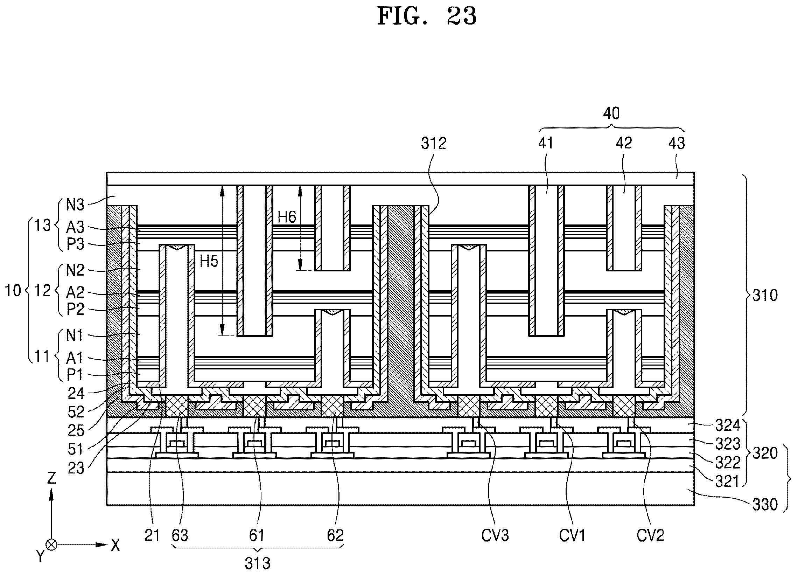

Referring to FIG. 23, the second electrode pattern 40 may be formed on the light-emitting structure 10. First, the fifth hole H5 exposing the n-type semiconductor layer N1 of the first light-emitting element 11 and the sixth hole H6 exposing the n-type semiconductor layer N2 of the second light-emitting element 12 may be formed, and the second insulating layer 22 provided on and surrounding side surfaces of the fifth hole H5 and the sixth hole H6 may be formed. The fifth hole H5 may penetrate the third light-emitting element 13 and the second light-emitting element 12, and the sixth hole H6 may penetrate the third light-emitting element 13, and thus the active areas A2 and A3 of the second light-emitting element 12 and the third light-emitting element 13 may be reduced. Therefore, the widths of the fifth hole H5 and the sixth hole H6 may be small such as less than or equal to about 1 µm or less than or equal to about 0.5 µm in the horizontal direction (X-direction and/or Y-direction, or a direction perpendicular to a thickness direction of the light-emitting structure).

The fifth hole H5 and the sixth hole H6 may be performed through a plasma etching process. Even though the fifth hole H5 and the sixth hole H6 are performed through the plasma etching process, the n-type semiconductor layer N1 of the exposed first light-emitting element 11 and the n-type semiconductor layer N2 of the second light-emitting element 12 may maintain the n-type semiconductor characteristics. Therefore, a separate process for restoring the n-type semiconductor characteristics may not be required.

The second electrode pattern 40 may be formed using the fifth hole H5 and the sixth hole H6. For example, the third electrode 41 may be formed on the n-type semiconductor layer N1 of the first light-emitting element 11 exposed through the fifth hole H5, the fourth electrode 42 may be formed on the n-type semiconductor layer N2 of the second light-emitting element 12 exposed through the sixth hole H6, and the sixth electrode 43 may be formed on the exposed n-type semiconductor layer N3 of the third light-emitting element 13. The sixth electrode 43 may be disposed on the n-type semiconductor layer N3 of the third light-emitting element 13 while being connected to the third electrode 41 and the fourth electrode 42. The sixth electrode 43 may cover the entire upper surface of the n-type semiconductor layer N3 of the third light-emitting element 13.

The second electrode pattern 40 may be formed on a surface (i.e., the surface of the third light-emitting element 13) different from a surface (i.e., the surface of the first light-emitting element 11) on which the first electrode pattern 30 is disposed among the surfaces of the light-emitting structure 10 after the light-emitting structure 10 is bonded to the backplane 301. Thus, the active areas of the first light-emitting element 11, the second light-emitting element 12, and the third light-emitting element 13 lost by the holes may remain substantially uniform. In addition, the first electrode pattern 30 and the second electrode pattern 40 may be disposed on different surfaces of the light-emitting structure 10, thereby simplifying a connection wiring between the first electrode pattern 30 and the second electrode pattern 40 and the corresponding circuit modules.

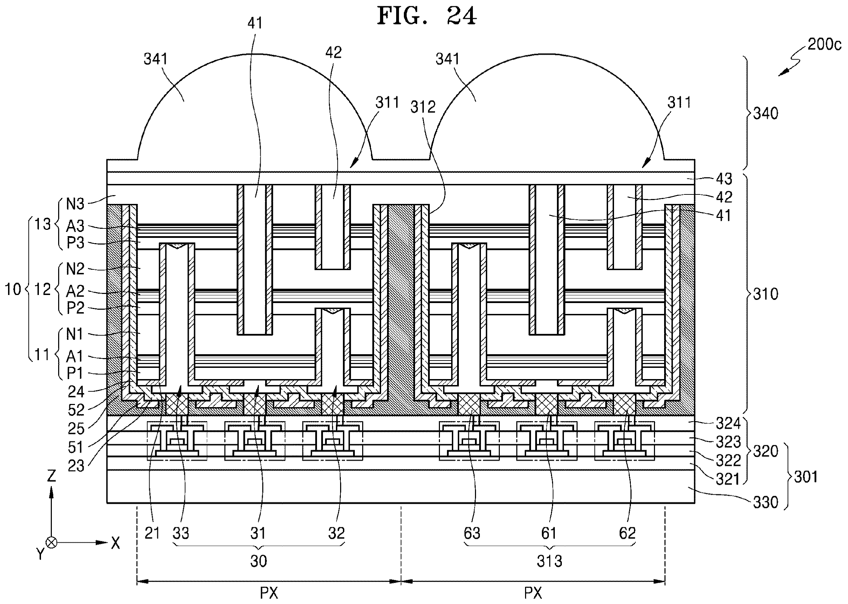

Referring to FIG. 24, the optical layer 340 may be formed on an upper surface of the light-emitting structure 10 (e.g., a surface of the third light-emitting element 13). The optical layer 340 may control a traveling path of light generated by the light-emitting structure 10. The microlens 341 is shown as an optical element in FIG. 24, but embodiments are not limited thereto. The optical element may be a microstructure such as a meta structure.

In the above-described display apparatuses 200, 200a, 200b, and 200c, one pixel providing all of blue light, green light, and red light may be implemented with one light-emitting element 311. Accordingly, the display apparatus 200 may provide an ultra-high resolution image or be implemented as a relatively small display apparatus. The display apparatus 200 may be applicable to various electronic devices having a screen display function.

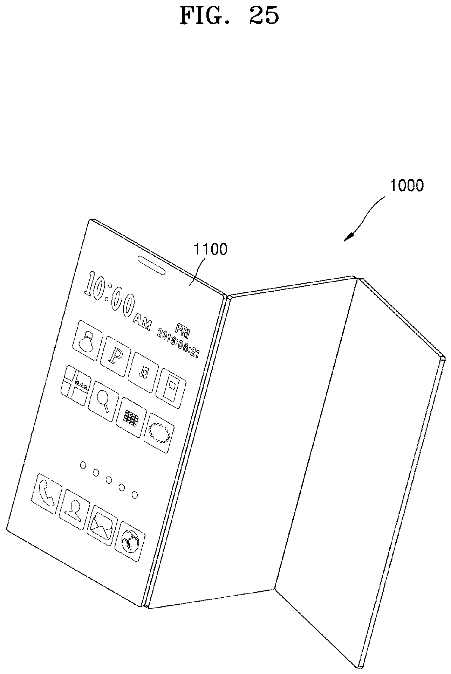

FIG. 25 is a diagram illustrating an example of applying a display apparatus according to one or more embodiments to a mobile device 1000. The mobile device 1000 may include a display apparatus 1100. The display apparatus 1100 may include the display apparatus 200, 200a, 200b, or 200c according to one or more embodiments. The display apparatus 1100 may have a foldable structure, and, for example, be implemented as a multi-foldable display. For example, the mobile device 1000 has been shown to have a folder type display, but may also have a flat type display.

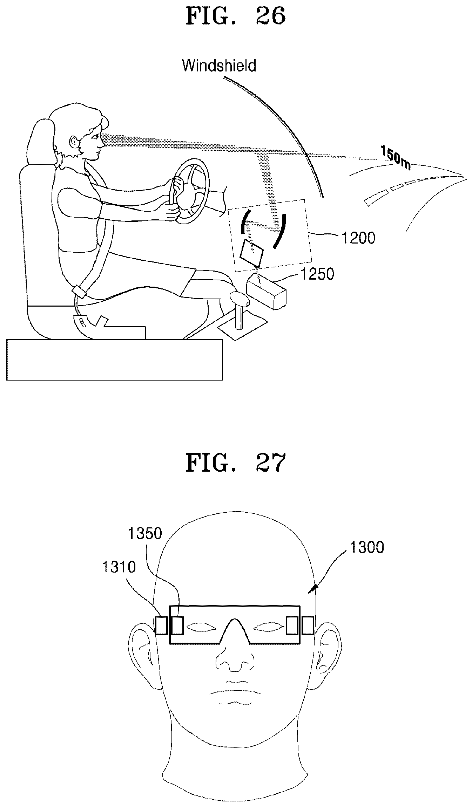

FIG. 26 is a diagram illustrating an example of applying a display apparatus 1250 according to one or more embodiments to a vehicle. The display apparatus 1250 may be a vehicle head-up display apparatus. The head-up display apparatus may include the display apparatus 1250 provided in an area of a vehicle, and at least one light path changing member 1200 that converts an optical path so that a driver may see an image generated on the display apparatus 1250. The display apparatus 1250 may include the display apparatus 200, 200a, 200b, or 200c according to one or more embodiments.

FIG. 27 is a diagram illustrating an example of applying a display apparatus according to one or more embodiments to augmented reality glasses 1300 or virtual reality glasses. The augmented reality glasses 1300 may include a projection system 1310 that forms an image, and at least one element 1350 that guides an image from the projection system 1310 into the user's eye. The projection system 1310 may include the display apparatuses 200, 200a, 200b, and 200c according to one or more embodiments.

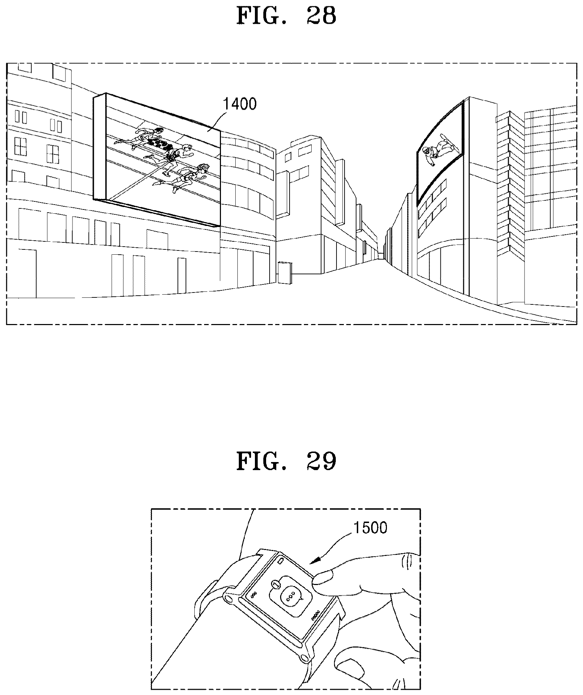

FIG. 28 is a diagram illustrating an example of applying a display apparatus according to one or more embodiments to a relatively large signage 1400. The signage 1400 may be used for outdoor advertisement using a digital information display, and may control advertisement contents through a communication network. The signage 1400 may include the display apparatus 200, 200a, 200b, or 200c according to one or more embodiments.

FIG. 29 is a diagram illustrating an example in which a display apparatus according to one or more embodiments is applied to a display 1500 of a wearable device. The display 1500 of a wearable device may be applied to the display apparatuses 200, 200a, 200b, and 200c according to one or more embodiments.

The display apparatuses 200, 200a, 200b, and 200c according to one or more embodiments may also be applied to various products such as a rollable TV, a stretchable display, etc.

The light-emitting device according to one or more embodiments may emit light of a plurality of different wavelengths.

In the light-emitting device according to one or more embodiments, a plurality of light-emitting elements are vertically stacked, and thus a relatively wide active layer may be ensured to increase light emission efficiency.

The light-emitting device according to one or more embodiments may be used to manufacture the display apparatus without a high-level transfer technology.

The light-emitting device according to one or more embodiments may have improved electrical characteristics between the light-emitting element and the electrode.

In addition to the detailed description above, the present disclosure may relate to any of the following clauses.

Clause 1. A light-emitting device comprising: a light-emitting structure comprising a first light-emitting element and a second light-emitting element sequentially and monolithically provided in a vertical direction, each of the first light-emitting element and the second light-emitting element comprising a p-type semiconductor layer, an active layer, and an n-type semiconductor layer and being configured to emit light of different wavelengths; a first electrode pattern comprising a first electrode and a second electrode electrically connected to the p-type semiconductor layer of the first light-emitting element and the p-type semiconductor layer of the second light-emitting element, respectively; and a second electrode pattern comprising a third electrode and a fourth electrode electrically connected to the n-type semiconductor layer of the first light-emitting element and the n-type semiconductor layer of the second light-emitting element, respectively, wherein the second electrode comprises: a first insulating hole penetrating the first light-emitting element in the vertical direction of the light-emitting device and exposing the p-type semiconductor layer of the second light-emitting element; a first p-type contact layer in the first insulating hole and contacting the p-type semiconductor layer of the second light-emitting element; and a first conductive layer contacting the first p-type contact layer.

Clause 2. The light-emitting device of clause 1, wherein a material of the first p-type contact layer is the same as a material of the p-type semiconductor layer of the second light-emitting element.

Clause 3. The light-emitting device of clause 1 or 2, wherein a content of a p-type dopant in the first p-type contact layer is greater than or equal to a content of a p-type dopant in the p-type semiconductor layer of the second light-emitting element.

Clause 4. The light-emitting device of any of the clauses 1-3, wherein the first p-type contact layer overlaps the first conductive layer in a horizontal direction.

Clause 5. The light-emitting device of any of the clauses 1-4, wherein a thickness of a peripheral area of the first p-type contact layer and a thickness of a central area of the first p-type contact layer in the vertical direction are different from each other.

Clause 6. The light-emitting device of any of the clauses 1-5, wherein a thickness of a peripheral area of the first p-type contact layer in the vertical direction gradually increases from the peripheral area of the first p-type contact layer to a central area of the first p-type contact layer.

Clause 7. The light-emitting device of any of the clauses 1-6, wherein a cross-sectional shape of the first p-type contact layer in the vertical direction of the light-emitting device is polygonal.

Clause 8. The light-emitting device of any of the clauses 1-7, wherein the first conductive layer contacts an r-plane surface of the first p-type contact layer.

Clause 9. The light-emitting device of any of the clauses 1-8, wherein the first conductive layer fills the first insulating hole and protrudes to a surface of the first light-emitting element.

Clause 10. The light-emitting device of any of the clauses 1-9, wherein the first p-type contact layer fills the first insulating hole and protrudes to a surface of the first light-emitting element.

Clause 11. The light-emitting device of any of the clauses 1-10, wherein a width of the first insulating hole is less than or equal to 1/5 of a width of the light-emitting structure in a horizontal direction.

Clause 12. The light-emitting device of any of the clauses 1-11, wherein the light-emitting structure does not comprise a bonding material.

Clause 13. The light-emitting device of any of the clauses 1-12, wherein the light-emitting structure comprises a third light-emitting element on the second light-emitting element, the third light-emitting element comprising a p-type semiconductor layer, an active layer, and an n-type semiconductor layer, and configured to emit light of a wavelength different from the first light-emitting element and the second light-emitting element, wherein the first electrode pattern comprises a fifth electrode electrically connected to the p-type semiconductor layer of the third light-emitting element, and wherein the second electrode pattern comprises a sixth electrode electrically connected to the n-type semiconductor layer of the third light-emitting element.

Clause 14. The light-emitting device of clause 13, wherein the fifth electrode comprises: a second insulating hole penetrating the first light-emitting element and the second light-emitting element in the vertical direction of the light-emitting device and exposing the p-type semiconductor layer of the third light-emitting element; a second p-type contact layer in the second insulating hole and contacting the p-type semiconductor layer of the third light-emitting element; and a second conductive layer contacting the second p-type contact layer.

Clause 15. The light-emitting device of clause 13 or 14, wherein the first electrode, the second electrode, and the fifth electrode are not electrically connected to each other.

Clause 16. The light-emitting device of any of the clauses 13-15, wherein the third electrode, the fourth electrode, and the sixth electrode are electrically connected to each other.

Clause 17. The light-emitting device of clause 16, wherein the sixth electrode contacts a surface of the third light-emitting element, the third electrode, and the fourth electrode.

Clause 18. A display apparatus comprising: a display layer comprising a plurality of light-emitting devices, at least one of the plurality of light-emitting devices comprising of a light-emitting structure, a first electrode pattern, and a second electrode pattern of any of the clauses 1-17; and a driving layer configured to drive the display layer, wherein a first light-emitting element and a second light-emitting element of the light-emitting structure are sequentially on the driving layer.

Clause 19. The display apparatus of clause 18, wherein the display layer comprises: a first light-emitting device and a second light-emitting device adjacent to each other; and a pixel partition configured to partition the first light-emitting device and the second light-emitting device.

Clause 20. A method of manufacturing a light-emitting device, the method comprising: forming, on a sacrificial layer, a light-emitting structure comprising a first light-emitting element and a second light-emitting element, each of the first light-emitting element and the second light-emitting element comprising a p-type semiconductor layer, an active layer, and an n-type semiconductor layer and being configured to emit light of different wavelengths; forming a first electrode pattern comprising a first electrode and a second electrode electrically connected to the p-type semiconductor layer of the first light-emitting element and the p-type semiconductor layer of the second light-emitting element, respectively; removing the sacrificial layer from the light-emitting structure; and forming a second electrode pattern comprising a third electrode and a fourth electrode electrically connected to the n-type semiconductor layer of the first light-emitting element and the n-type semiconductor layer of the second light-emitting element, respectively, wherein the forming of the first electrode pattern comprises: forming a first insulating hole penetrating the first light-emitting element in a vertical direction of the light-emitting device and exposing the p-type semiconductor layer of the second light-emitting element; forming a first p-type contact layer contacting the p-type semiconductor layer of the second light-emitting element in the first insulating hole; and forming a first conductive layer contacting the first p-type contact layer.

It should be understood that embodiments described herein should be considered in a descriptive sense only and not for purposes of limitation. Descriptions of features or aspects within each embodiment should typically be considered as available for other similar features or aspects in other embodiments. While embodiments have been described with reference to the figures, it will be understood by those of ordinary skill in the art that various changes in form and details may be made therein without departing from the scope as defined by the following claims.

## Claims

1. A light-emitting device, comprising:
a light-emitting structure comprising a first light-emitting element and a second light-emitting element sequentially and monolithically provided in a vertical direction, each of the first light-emitting element and the second light-emitting element comprising a p-type semiconductor layer, an active layer, and an n-type semiconductor layer and being configured to emit light of different wavelengths;
a first electrode pattern comprising a first electrode and a second electrode electrically connected to the p-type semiconductor layer of the first light-emitting element and the p-type semiconductor layer of the second light-emitting element, respectively; and
a second electrode pattern comprising a third electrode and a fourth electrode electrically connected to the n-type semiconductor layer of the first light-emitting element and the n-type semiconductor layer of the second light-emitting element, respectively,
wherein the second electrode comprises:
a first insulating hole penetrating the first light-emitting element in the vertical direction of the light-emitting device and exposing the p-type semiconductor layer of the second light-emitting element;
a first p-type contact layer in the first insulating hole and contacting the p-type semiconductor layer of the second light-emitting element; and
a first conductive layer contacting the first p-type contact layer.

2. The light-emitting device of claim **1,** wherein a material of the first p-type contact layer is the same as a material of the p-type semiconductor layer of the second light-emitting element.

3. The light-emitting device of claim 1 or 2, wherein a content of a p-type dopant in the first p-type contact layer is greater than or equal to a content of a p-type dopant in the p-type semiconductor layer of the second light-emitting element.

4. The light-emitting device of any one of the previous claims, wherein the first p-type contact layer overlaps the first conductive layer in a horizontal direction.

5. The light-emitting device of any one of the previous claims, wherein a thickness of a peripheral area of the first p-type contact layer and a thickness of a central area of the first p-type contact layer in the vertical direction are different from each other: and/or
wherein a thickness of a peripheral area of the first p-type contact layer in the vertical direction gradually increases from the peripheral area of the first p-type contact layer to a central area of the first p-type contact layer.

6. The light-emitting device of any one of the previous claims, wherein a cross-sectional shape of the first p-type contact layer in the vertical direction of the light-emitting device is polygonal.

7. The light-emitting device of any one of the previous claims, wherein the first conductive layer contacts an r-plane surface of the first p-type contact layer.

8. The light-emitting device of any one of the previous claims, wherein the first conductive layer and/or the first p-type contact layer fills the first insulating hole and protrudes to a surface of the first light-emitting element.

9. The light-emitting device of any one of the previous claims, wherein a width of the first insulating hole is less than or equal to 1/5 of a width of the light-emitting structure in a horizontal direction; and/or
wherein the light-emitting structure does not comprise a bonding material.

10. The light-emitting device of any one of the previous claims, wherein the light-emitting structure comprises a third light-emitting element on the second light-emitting element, the third light-emitting element comprising a p-type semiconductor layer, an active layer, and an n-type semiconductor layer, and configured to emit light of a wavelength different from the first light-emitting element and the second light-emitting element,
wherein the first electrode pattern comprises a fifth electrode electrically connected to the p-type semiconductor layer of the third light-emitting element, and
wherein the second electrode pattern comprises a sixth electrode electrically connected to the n-type semiconductor layer of the third light-emitting element.

11. The light-emitting device of claim 10, wherein the fifth electrode comprises:
a second insulating hole penetrating the first light-emitting element and the second light-emitting element in the vertical direction of the light-emitting device and exposing the p-type semiconductor layer of the third light-emitting element;
a second p-type contact layer in the second insulating hole and contacting the p-type semiconductor layer of the third light-emitting element; and
a second conductive layer contacting the second p-type contact layer.

12. The light-emitting device of claim 10 or 11, wherein the first electrode, the second electrode, and the fifth electrode are not electrically connected to each other; and/or
wherein the third electrode, the fourth electrode, and the sixth electrode are electrically connected to each other, wherein the sixth electrode preferably contacts a surface of the third light-emitting element, the third electrode, and the fourth electrode.

13. A display apparatus, comprising:
a display layer comprising a plurality of light-emitting devices, wherein at least one of the plurality of light-emitting devices is defined according to any of the previous claims; and
a driving layer configured to drive the display layer,
wherein a first light-emitting element and a second light-emitting element of the light-emitting structure are sequentially on the driving layer.

14. The display apparatus of claim 13, wherein the display layer comprises:
a first light-emitting device and a second light-emitting device adjacent to each other; and
a pixel partition configured to partition the first light-emitting device and the second light-emitting device.

15. A method of manufacturing a light-emitting device, the method comprising:
forming, on a sacrificial layer, a light-emitting structure comprising a first light-emitting element and a second light-emitting element, each of the first light-emitting element and the second light-emitting element comprising a p-type semiconductor layer, an active layer, and an n-type semiconductor layer and being configured to emit light of different wavelengths;
forming a first electrode pattern comprising a first electrode and a second electrode electrically connected to the p-type semiconductor layer of the first light-emitting element and the p-type semiconductor layer of the second light-emitting element, respectively;
removing the sacrificial layer from the light-emitting structure; and
forming a second electrode pattern comprising a third electrode and a fourth electrode electrically connected to the n-type semiconductor layer of the first light-emitting element and the n-type semiconductor layer of the second light-emitting element, respectively,
wherein the forming of the first electrode pattern comprises:
forming a first insulating hole penetrating the first light-emitting element in a vertical direction of the light-emitting device and exposing the p-type semiconductor layer of the second light-emitting element;
forming a first p-type contact layer contacting the p-type semiconductor layer of the second light-emitting element in the first insulating hole; and
forming a first conductive layer contacting the first p-type contact layer.
